# EUROPEAN PATENT SPECIFICATION

(11) **EP 0 607 841 B1**
(45) Date of publication and mention of the grant of the patent: **12.04.2000**
(21) Application number: 94100291.7
(22) Date of filing: 11.01.1994
(51) Int. Cl.: G06G 7/164

(54) **Analog multiplier using four-transistor stages**
Analog Multiplizierer mit Viertransistorstufen
Multiplicateur analogique utilisant des étages à quatre transistors

(30) Priority: 11.01.1993 JP 1935893
(43) Date of publication of application: 27.07.1994
(73) Proprietor: NEC CORPORATION, Tokyo (JP)
(72) Inventor: Kimura, Katsuji, c/o NEC Corporation, Minato-ku, Tokyo (JP)
(74) Representative: VOSSIUS & PARTNER

(56) References cited:
- GB-A- 2 256 550
- IEICE TRANSACTIONS ON FUNDAMENTALS, vol.E75-A, no.12, December 1992, TOKYO JP pages 1774 - 1776 KIMURA 'An MOS Operational Transconductance Amplifier and an MOS Four-Quadrant Analog Multiplier Using the Quadritail Cell'
- IEICE TRANSACTIONS ON ELECTRONICS, vol.E76-C, no.5, May 1993, TOKYO JP pages 714 - 737 KIMURA 'A Unified Analysis of Four-Quadrant Analog Multipliers'
- IEEE JOURNAL OF SOLID-STATE CIRCUITS, vol.26, no.9, September 1991, NEW YORK US pages 1293 - 1301 WANG 'A CMOS Four-Quadrant Analog Multiplier with Single-Ended Voltage Output and Improved Temperature Performance'
- ELECTRONICS & WIRELESS WORLD, vol.91, no.1596, October 1985, SURREY GB pages 27 - 31 LIDGEY 'The tale of the longtail pair - part 2'

## Description

The present invention relates a multiplier and more particularly, to a multiplier for two analog signals using quadritail circuits formed of bipolar transistors or Metal-Oxide-Semiconductor (MOS) transistors, which is realized on semiconductor integrated circuits.

An analog multiplier constitutes a functional circuit block essential for analog signal applications. Recently, semiconductor integrated circuits have been made finer and finer and as a result, their power source voltages have been decreasing from 5 V to 3.3 or 3 V. Under such a circumstance, low-voltage circuits which can be operated at such a low voltage as 3 V has been required to be developed. In the case, the linear ranges of the input voltages of the multipliers need to be wide as much as possible.

A Gilbert multiplier cell is well known as a bipolar multiplier. However, the Gilbert multiplier cell has such a structure that bipolar transistor-pairs are provided in a two-stage stacked manner and as a result, it cannot respond to reduction of the operating power source voltage.

Besides, the Complementary MOS (CMOS) technology has become recognized to be the optimum process technology for Large Scale Integration (LSI), so that multipliers which can be realized using the CMOS technology have been required.

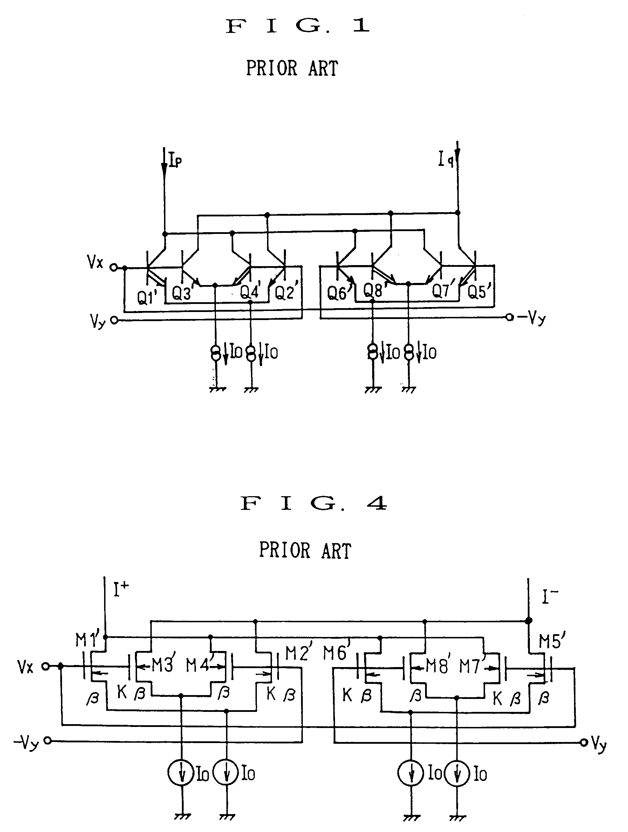

The inventor developed multipliers as shown in Figs 1, 4 and 7 and filed Japanese patent applications about them. With these prior-art multipliers, two squaring circuits are arranged so-called in a line transversely, not in a stack manner, to be driven by the same power source voltage. The circuit configuration was developed based on the fact that the product of first and second input voltages is given by subtracting the square of the difference of the first and second input voltages from the square of the sum thereof.

The above prior-art multipliers developed by the inventor were named as "quarter-square multipliers" since the constant "4" of involution contained in the term of the product was changed to "1".

First, the prior-art multiplier shown in Fig. 1 is disclosed in the Japanese Non-Examined Patent Publication No. 5 - 94552 (Japanese Patent Application No. 4 - 72629). In Fig. 1, the multiplier includes a first squaring circuit made of bipolar transistors Q1', Q2', Q3' and Q4' and a second squaring circuit made of bipolar transistors Q5', Q6', Q7' and Q8'.

In the first squaring circuit, the transistors Q1' and Q2' form a first unbalanced differential pair driven by a first constant current source (current :I₀ ) and the transistors Q3' and Q4' form a second unbalanced differential pair driven by a second constant current source (current: I₀). The transistor Q1' is **K** times in emitter size or area as much as the transistor Q2' and the transistor Q4' is **K** times in emitter size as much as the transistor Q3'.

Emitters of the transistors Q1' and Q2' are connected in common to the first constant current source, and emitters of the transistors Q3' and Q4' are connected in common to the second constant current source.

In the second squaring circuit, the transistors Q5' and Q6' form a third unbalanced differential pair driven by a third constant current source (current: I₀) and the transistors Q7' and Q8' form a fourth unbalanced differential pair driven by a fourth constant current source (current: I₀). The transistor Q5' is **K** times in emitter size as much as the transistor Q6' and the transistor Q8' is **K** times in emitter size as much as the transistor Q7'.

Emitters of the transistors Q5' and Q6' are connected in common to the third constant current source, and emitters of the transistors Q7' and Q8' are connected in common to the fourth constant current source.

Bases of the transistors Q1' and Q3' are coupled together to be applied with a first input voltage Vₓ, and bases of the transistors Q2' and Q4' are coupled together to be applied with a second input voltage V_{y}.

Bases of the transistors Q5' and Q7' are coupled together to be applied with the first input voltage Vₓ, and bases of the transistors Q6' and Q8' are coupled together to be applied in opposite phase with the second input voltage V_{y}, or -V_{y}.

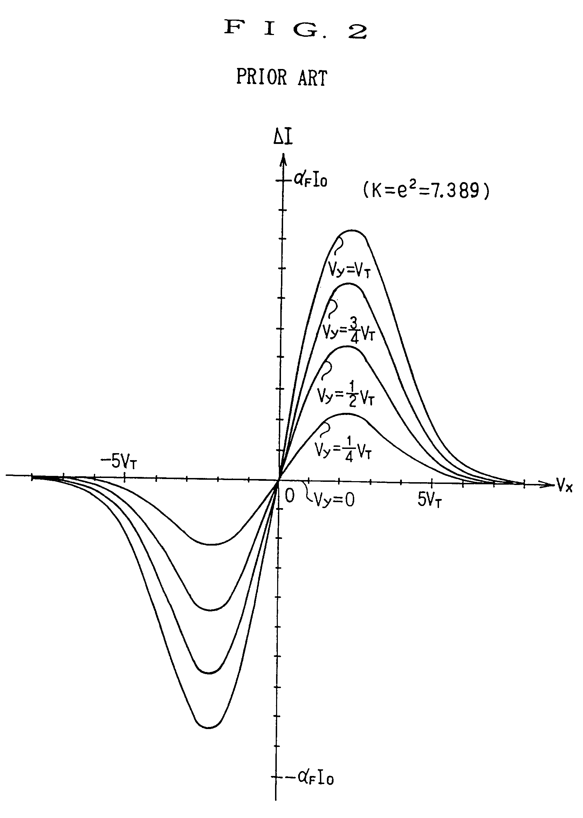

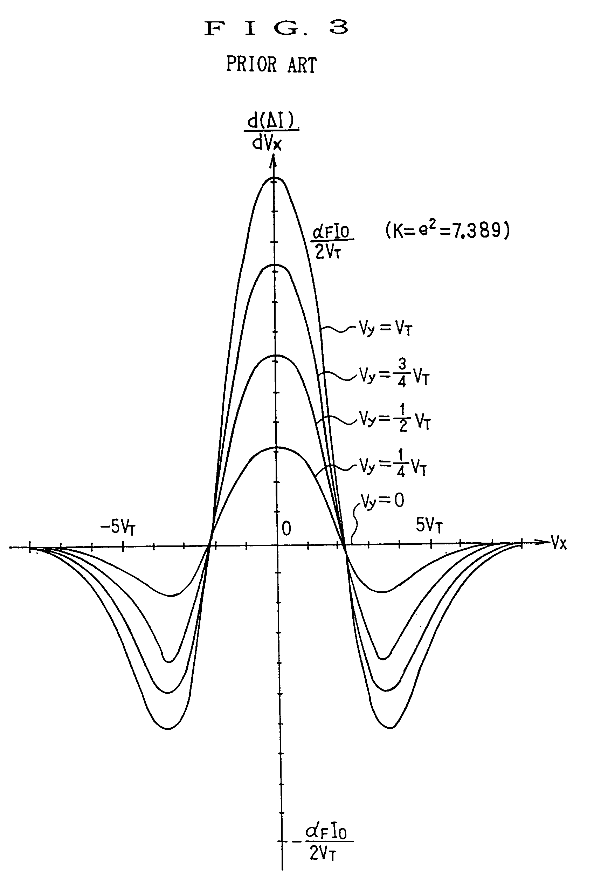

The transfer characteristics and the transconductance characteristics of the multiplier are shown in Figs. 2 and 3, respectively, where **K** is e² (≒ 7.389). A differential output current ΔI shown in Fig. 2 is defined as the difference of output currents Iₚ and I_{q} shown in Fig. 1, or (Iₚ - I_{q}).

Fig. 2 shows the relationship between the differential output current ΔI and the first input voltage Vₓ with the second input voltage V_{y} as a parameter. Fig. 3 shows the relationship between the transconductance (dΔI/dVₓ) and the first input voltage Vₓ with the second input voltage V_{y} as a parameter.

Second, the prior-art multiplier developed by the inventor shown in Fig. 4 is disclosed in the Japanese Non-Examined Patent Publication No. 4 - 34673 (1992). In Fig. 4, the multiplier includes a first squaring circuit made of MOS transistors M1', M2', M3' and M4' and a second squaring circuit made of MOS transistors M5', M6', M7' and M8'.

In the first squaring circuit, the transistors M1' and M2' form a first unbalanced differential pair driven by a first constant current source (current :I₀), and the transistors M3' and M4' form a second unbalanced differential pair driven by a second constant current source (current: I₀). The transistor M2' is **K** times in ratio (**W/L**) of a gate-width **W** to a gate-length **L** as much as the transistor M1', and the transistor M3' is **K** times in ratio (**W/L**) of a gate-width **W** to a gate-length **L** as much as the transistor M4'.

Sources of the transistors M1' and M2' are connected in common to the first constant current source, and sources of the transistors M3' and M4' are connected in common to the second constant current source.

In the second squaring circuit, the transistors M5' and M6' form a third unbalanced differential pair driven by a third constant current source (current: I₀), and the transistors M7' and M8' form a fourth unbalanced differential pair driven by a fourth constant current source (current: I₀). The transistor M6' is **K** times in ratio (**W/L**) of a gate-width **W** to a gate-length **L** as much as the transistor M5', and the transistor M7' is **K** times in ratio (**W/L**) of a gate-width **W** to a gate-length **L** as much as the transistor M8'.

Sources of the transistors M5' and M6' are connected in common to the third constant current source, and sources of the transistors M7' and M8' are connected in common to the fourth constant current source.

Gates of the transistors M1' and M3' are coupled together to be applied with a first input voltage Vₓ, and gates of the transistors M2' and M4' are coupled together to be applied in opposite phase with a second input voltage V_{y}, or -V_{y}.

Gates of the transistors M5' and M7' are coupled together to be applied with the first input voltage Vₓ, and gates of the transistors M6' and M8' are coupled together to be applied with the second input voltage V_{y}.

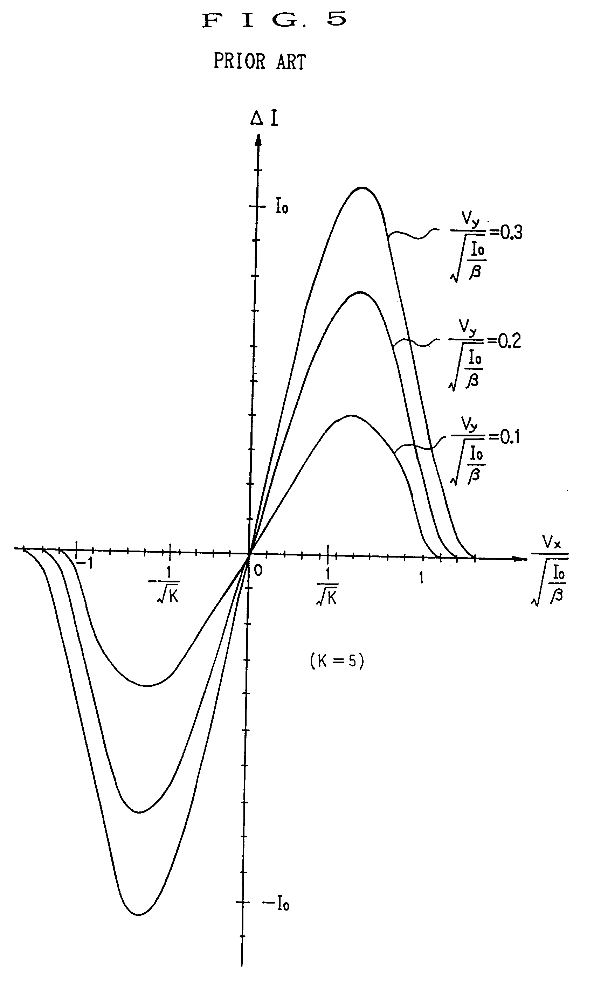

In Fig. 4, the transconductance parameters of the transistors M1', M4', M5' and M8' are equal to be β, and those of the transistors M2', M3', M6' and M7' are equal to be **K**β.

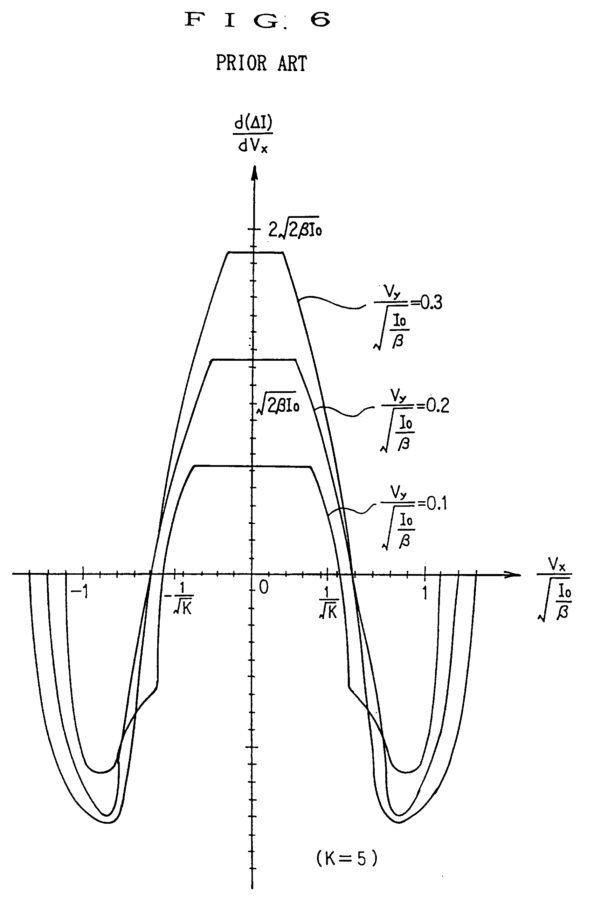

The transfer characteristics and the transconductance characteristics of the multiplier are shown in Figs. 5 and 6, respectively, where **K** is 5. A differential output current ΔI shown in Fig. 5 is defined as the difference of output currents I⁺ and I⁻ shown in Fig. 4, or (I⁺ - I⁻).

Fig. 5 shows the relationship between the differential output current ΔI and the first input voltage Vₓ with the second input voltage V_{y} as a parameter. Fig. 6 shows the relationship between the transconductance (dΔI/dVₓ) and the first input voltage Vₓ with the second input voltage V_{y} as a parameter.

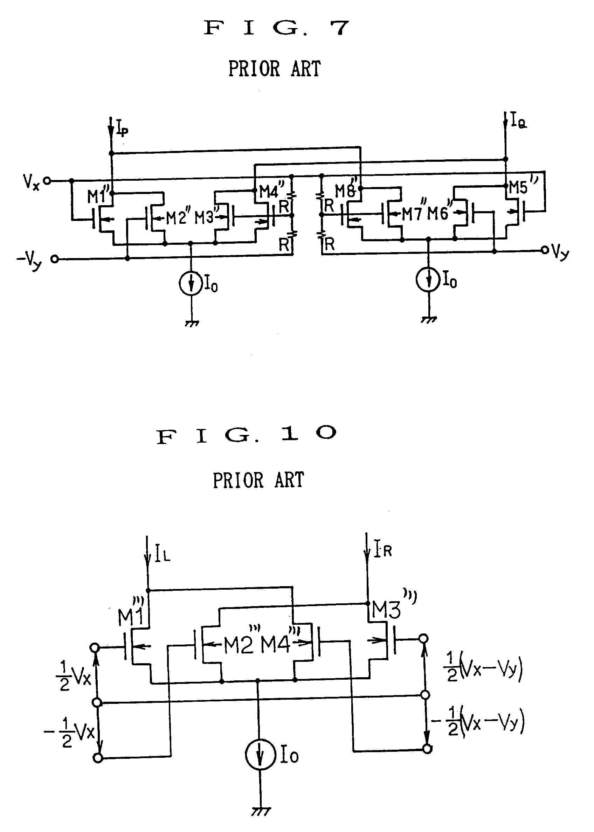

Third, the prior-art multiplier developed by the inventor shown in Fig. 7 is disclosed in IEICE TRANSACTIONS ON FUNDAMENTALS, Vol. E75-A, No. 12, December, 1992. In Fig. 7, the multiplier includes a first squaring circuit made of MOS transistors M1'', M2'', M3'' and M4'' and a first constant current source (current: I₀) for driving the transistors M1'', M2'', M3'' and M4'', and a second squaring circuit made of MOS transistors M5'', M6'', M7'' and M8'' and a second constant current source (current: I₀) for driving the transistors M5'', M6'', M7'' and M8''. The transistors M1'', M2'', M3'', M4'', M5'', M6'', M7'' and M8'' are equal in capacity or ratio (**W/L**) of a gate-width **W** to a gate-length **L** to each other.

The first and second squaring circuits are named as "quadritail circuits" or "quadritail cells", respectively.

In the first quadritail circuit, sources of the transistors M1'', M2'', M3'' and M4'' are connected in common to the first constant current source. Drains of the transistors M1'' and M2'' are coupled together and drains of the transistors M3'' and M4'' are coupled together. A gate of the transistor M1'' is applied with a first input voltage Vₓ, and a gate of the transistor M2'' is applied in opposite phase with a second input voltage V_{y}, or -V_{y}. Gates of the transistor M3'' and M4'' are coupled together to be applied with a middle point voltage of the voltage applied between the gates of the transistors M1'' and M2'', or (1/2) (Vₓ + V_{y}), which is obtained through resistors (resistance: R).

Similarly, in the second quadritail circuit, sources of the transistors M5'', M6'', M7'' and M8'' are connected in common to the second constant current source. Drains of the transistors M5'' and M6'' are coupled together and drains of the transistors M7'' and M8'' are coupled together. A gate of the transistor M5'' is applied with the first input voltage Vₓ, and a gate of the transistor M6'' is applied with the second input voltage V_{y}. Gates of the transistor M7'' and M8'' are coupled together to be applied with a middle point voltage of the voltage applied between the gates of the transistors M5'' and M6'', or (1/2)(Vₓ -V_{y}), which is obtained through resistors (resistance: R).

Between the first and second quadritail circuits, the drains coupled together of the transistors M1'' and M2'' and the drains coupled together of the transistors M7'' and M8'' are further coupled together to form one of differential output ends of the multiplier. The drains coupled together of the transistors M3'' and M4'' and the drains coupled together of the transistors M5'' and M6'' are further coupled together to form the other of the differential output ends thereof.

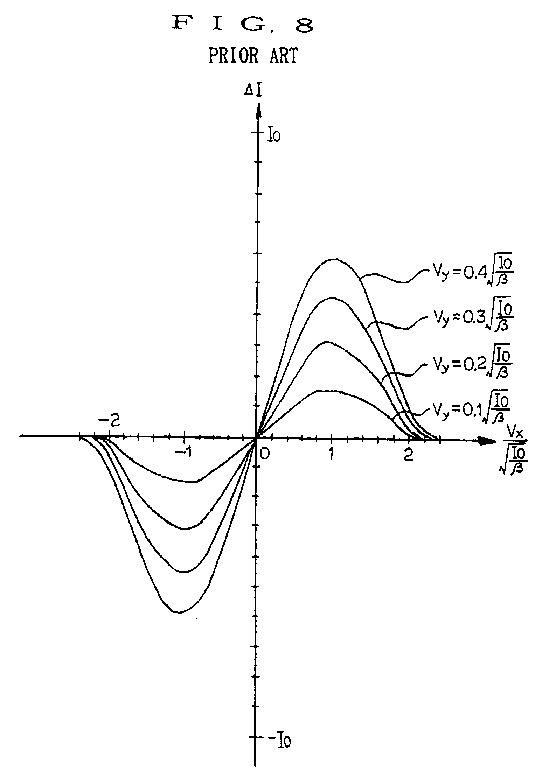

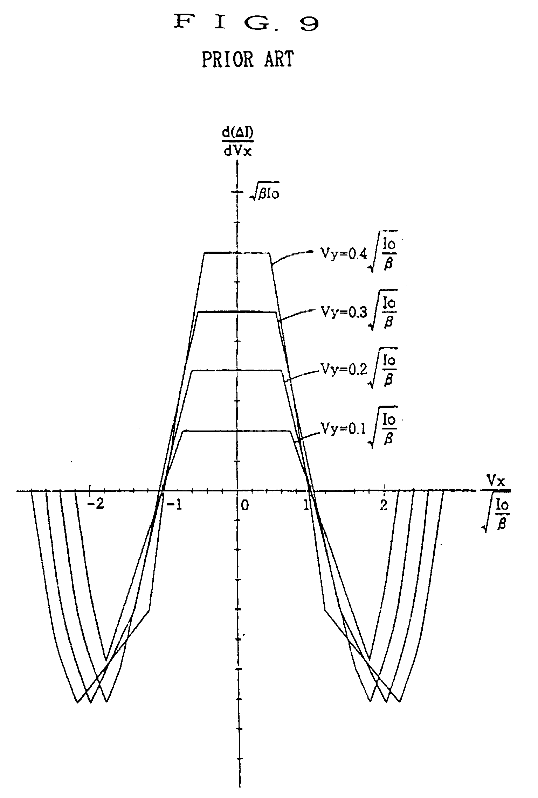

The transfer characteristics and the transconductance characteristics of the multiplier are shown in Figs. 8 and 9, respectively. A differential output current ΔI shown in Fig. 8 is defined as the difference of output currents I_{P} and I_{Q} shown in Fig. 7, or (I_{P}-I_{Q}).

Fig. 8 shows the relationship between the differential output current ΔI and the fist input voltage Vₓ with the second input voltage V_{y} as a parameter. Fig. 9 shows the relationship between the transconductance (dΔI/dVₓ) and the first input voltage Vₓ with the second input voltage V_{y} as a parameter.

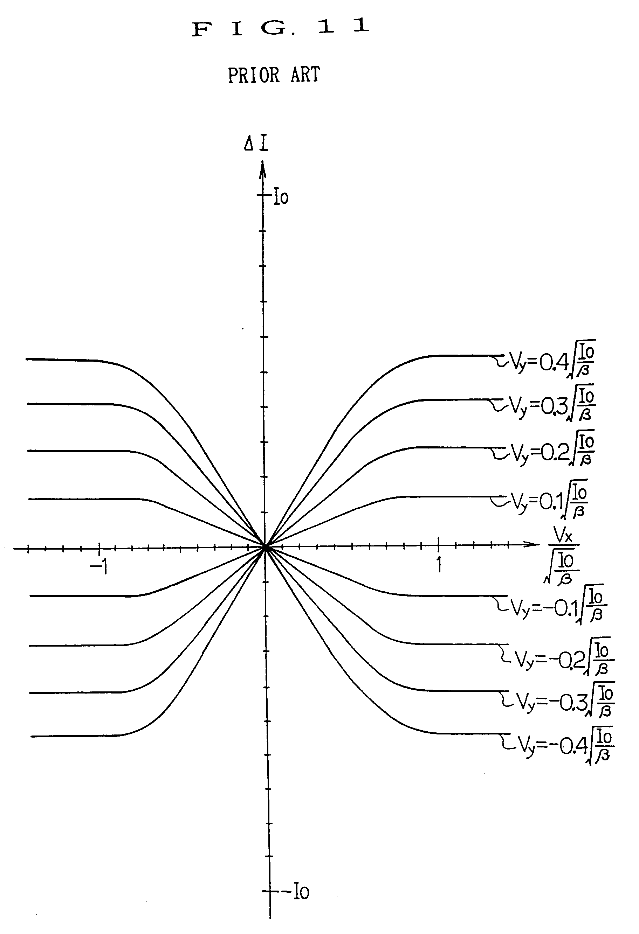

Fourth, the prior-art multiplier shown in Fig. 10 was developed by Wang, which is disclosed in IEEE journal of Solid-State Circuits, Vol. 26, No. 9, September, 1991. The circuit in Fig. 10 is modified by the inventor to clarify its characteristics.

In Fig. 10, the multiplier includes one quadritail circuit made of MOS transistors M1''', M2''', M3''' and M4''' and a constant current source (current: I₀) for driving the transistors M1'', M2'', M3'' and M4''. The transistors M1''', M2''', M3''' and M4''' are equal in capacity (**W/L**) to each other.

Sources of the transistors M1''', M2''', M3''' and M4''' are connected in common to the constant current source. Drains of the transistors M1''' and M4''' are coupled together to form one of differential output ends of the multiplier, and drains of the transistors M2''' and M3''' are coupled together to form the other of the differential output ends thereof.

A gate of the transistor M1''' is applied with a first input voltage (1/2)Vₓ based on a reference point, and a gate of the transistor M2''' is applied in opposite phase with the first input voltage Vₓ, or -Vₓ based on the reference point. A gate of the transistor M3''' is applied with a voltage of the half difference of the first input voltage and a second input voltage, or (1/2)(Vₓ - V_{y}). A gate of the transistor M4''' is applied with the voltage (1/2)(Vₓ - V_{y}) in opposite phase, or (-1/2)(Vₓ - V_{y}).

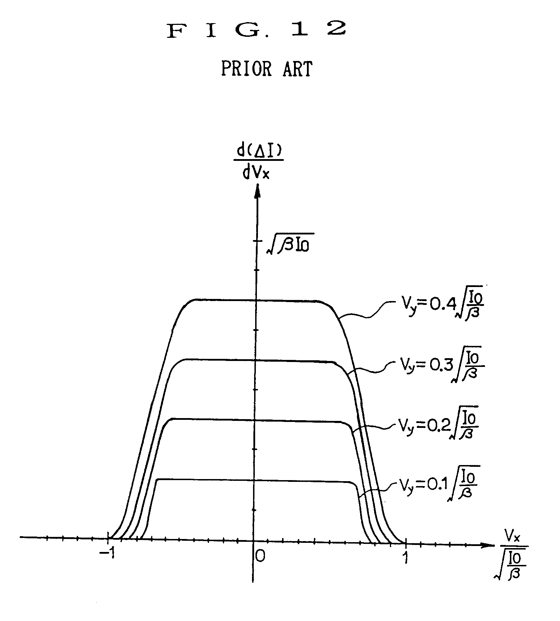

The transfer characteristics and the transconductance characteristics of the multiplier, which were obtained through analysis by the inventor, are shown in Figs. 11 and 12, respectively. A differential output current ΔI shown in Fig. 11 is defined as the difference of output currents I_{L} and I_{R} shown in Fig. 10, or (I_{L} -I_{R}).

Fig. 11 shows the relationship between the differential output current ΔI and the first input voltage Vₓ with the second input voltage V_{y} as a parameter. Fig. 12 shows the relationship between the transconductance (dΔI/dVₓ) and the first input voltage Vₓ with the second input voltage V_{y} as a parameter.

The prior-art multiplier formed of bipolar transistors shown in Fig. 1 has input voltage ranges of superior linearity which is substantially equal to those of the Gilbert multiplier cell. The prior-art multipliers shown in Fig. 4, 7 and 10, each of which is MOS transistors, have input voltage ranges of superior linearity comparatively wider than those of the Gilbert multiplier cell, respectively. However, when operating at a low power source voltage such as 3 or 3.3 V, input voltage ranges of superior linearity cannot be expanded in all of the prior-art multipliers.

Accordingly, an object of the present invention is to provide an analog multiplier in which at least one of two input voltages to be multiplied can be expanded in superiorly linear range compared with those of the prior-art multipliers even if operating at a low power source voltage such as 3 or 3.3 V.

A multiplier according to the present invention is specified in claims 1 and 5 and has first and second quadritail circuits.

The first quadritail cell contains a first pair of first and second transistors whose capacities are the same and whose output ends are coupled together, a second pair of third and fourth transistors whose capacities are the same and whose output ends are coupled together, and a first constant current source for driving the first and second differential pairs.

The second quadritail cell contains a third pair of fifth and sixth transistors whose capacities are the same and whose output ends are coupled together, a fourth pair of seventh and eighth transistors whose capacities are the same and whose output ends are coupled together, and a second constant current source for driving the third and fourth differential pairs.

In the first quadritail cell, a first input voltage is applied between input ends of the first and fourth transistors, and input ends of the second and third transistors are coupled together.

In the second quadritail cell, the first input voltage is applied between input ends of the fifth and eighth transistors, and input ends of the sixth and seventh transistors are coupled together.

A second input voltage is applied between the input ends coupled of the second and third transistors and the input ends coupled of the sixth and seventh transistors.

The output ends coupled together of the first differential pair and those coupled together of the fourth differential pair are coupled together to form one of output ends of the multiplier. The output ends coupled together of the second differential pair and those coupled together of the third differential pair are coupled together to form the other of the output ends thereof.

The first to eighth transistors are either bipolar transistors or MOS transistors.

Here, the "capacity" of the transistor means an emitter size of emitter area in bipolar transistors, and it means a ratio (**W/L**) of a gate-width and a gate-length in MOS transistors.

With the multiplier according to the present invention, there are provided with the first and second quadritail circuits, and the first to fourth differential pairs forming the both quadritail circuits are arranged so-called in a line transversely, not in a stack manner, to be driven by the same power source voltage. As a result, the multiplier of the present invention can be operated at a low power source voltage such as 3 or 3.3 V.

Also, the first transistor of the first pair and the fourth transistor of the second pair compose a first differential pair, and the second transistor of the first pair and the third transistor of the second pair also compose a second differential pair. Similarly, the fifth transistor of the third pair and the eighth transistor of the fourth pair compose a third differential pair, and the sixth transistor of the third pair and the seventh transistor of the fourth pair compose a fourth differential pair. Further, the output ends coupled together of the first quadritail cell and those coupled together of the second quadritail cell are respectively coupled together in opposite phase, that is, they are cross-coupled.

As a result, at least one of the first and second input voltages can be expanded in superiorly linear range at a low power source voltage such as 3 or 3.3 V.

In a preferred embodiment, the first to eighth transistors are bipolar transistors, each of which has a resistor connected to the corresponding emitter.

In another preferred embodiment, the first to eighth transistors are bipolar transistors, each of which has at least one diode connected to the corresponding emitter.

In these preferred embodiments, there is an additional advantage that at least one of the input voltages can be further expanded in superiorly linear range.
Fig. 1 is a circuit diagram showing a first example of the prior-art multipliers.
Fig. 2 shows the transfer characteristics of the prior-art multiplier shown in Fig. 1.
Fig. 3 shows the output characteristics of the prior-art multiplier shown in Fig. 1.
Fig. 4 is a circuit diagram showing a second example of the prior-art multipliers.
Fig. 5 shows the transfer characteristics of the prior-art multiplier shown in Fig. 4.
Fig. 6 shows the output characteristics of the prior-art multiplier shown in Fig. 4.
Fig. 7 is a circuit diagram showing a third example of the prior-art multipliers.
Fig. 8 shows the transfer characteristics of the prior-art multiplier shown in Fig. 7.
Fig. 9 shows the output characteristics of the prior-art multiplier shown in Fig. 7.
Fig. 10 is a circuit diagram showing a fourth example of the prior-art multipliers.
Fig. 11 shows the transfer characteristics of the prior-art multiplier shown in Fig. 10.
Fig. 12 shows the output characteristics of the prior-art multiplier shown in Fig. 10.
Fig. 13 is a circuit diagram of a multiplier according to a first embodiment of the present invention.
Fig. 14 shows the transfer characteristics of the multiplier of the first embodiment shown in Fig. 13, in which the relationship between the differential output current ΔI_{B} and the first input voltage Vₓ is shown with the second input voltage V_{y} as a parameter.
Fig. 15 shows the transfer characteristics of the multiplier of the first embodiment shown in Fig. 13, in which the relationship between the differential output current ΔI_{B} and the second input voltage V_{y} is shown with the first input voltage Vₓ as a parameter.
Fig. 16 shows the transconductance characteristics of the multiplier of the first embodiment shown in Fig. 13, in which the relationship between the transconductance (dΔI_{B}/dVₓ) and the first input voltage Vₓ with the second input voltage V_{y} as a parameter.
Fig. 17 shows the transconductance characteristics of the multiplier of the first embodiment shown in Fig. 13, in which the relationship between the transconductance (dΔI_{B}/dV_{y}) and the second input voltage V_{y} with the first input voltage Vₓ as a parameter.
Fig. 18 is a circuit diagram of a multiplier according to a second embodiment of the present invention.
Fig. 19 shows the transfer characteristics of the multiplier of the second embodiment shown in Fig. 18, in which the relationship between the differential output current ΔI_{M} and the first input voltage Vₓ is shown with the second input voltage V_{y} as a parameter.
Fig. 20 shows the transfer characteristics of the multiplier of the second embodiment shown in Fig. 18, in which the relationship between the differential output current ΔI_{M} and the second input voltage V_{y} is shown with the first input voltage Vₓ as a parameter.
Fig. 21 shows the transconductance characteristics of the multiplier of the second embodiment shown in Fig. 18, in which the relationship between the transconductance (dΔI_{M}/dVₓ) and the first input voltage Vₓ with the second input voltage V_{y} as a parameter.
Fig. 22 shows the transconductance characteristics of the multiplier of the second embodiment shown in Fig. 18, in which the relationship between the transconductance (dΔI_{M}/dV_{y}) and the second input voltage V_{y} with the first input voltage Vₓ as a parameter.
Fig. 23 is a circuit diagram of a multiplier according to a third embodiment of the present invention.
Fig. 24 is a circuit diagram of a multiplier according to a fourth embodiment of the present invention.

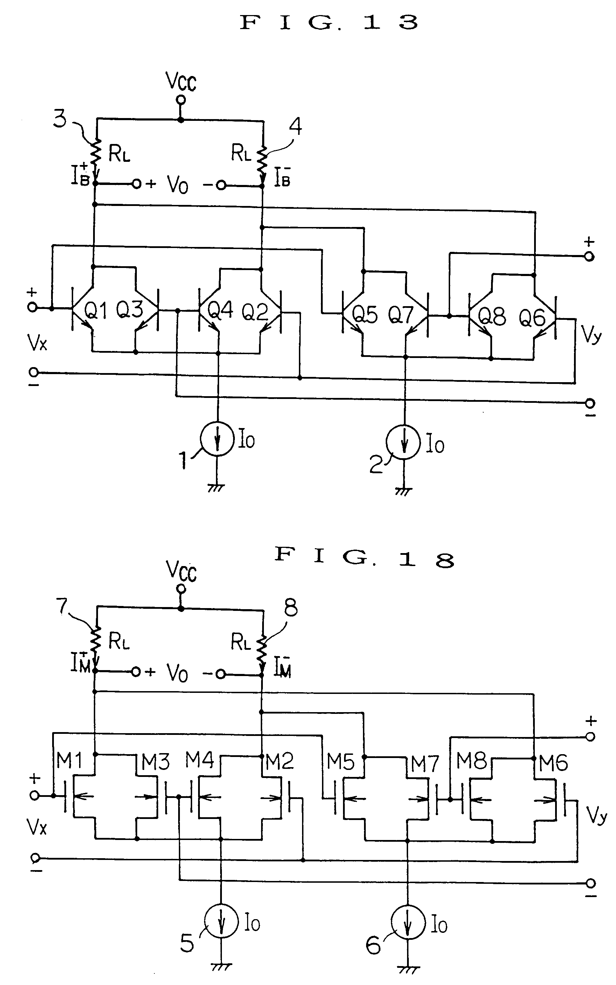

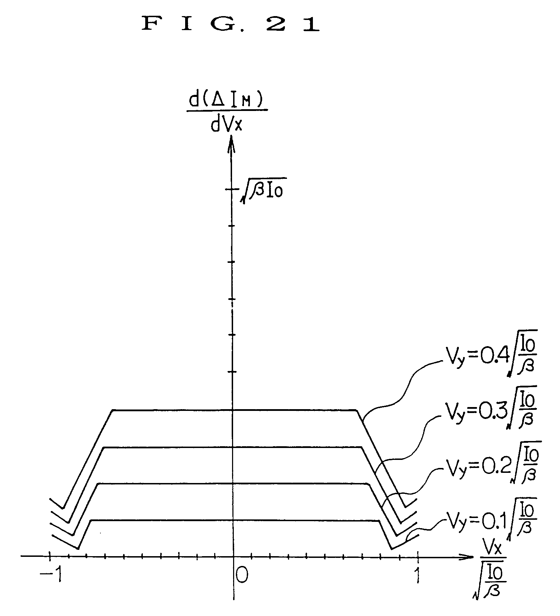

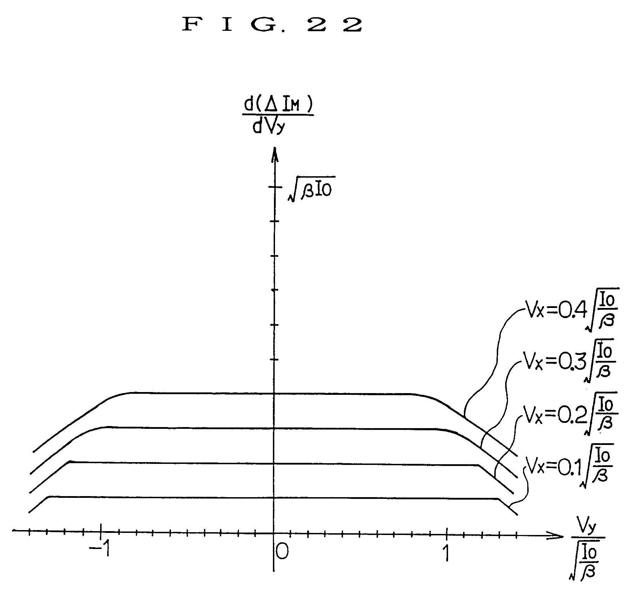

Preferred embodiments of the present invention will be described below referring to Figs. 13 to 24.

### [First Embodiment]

Figs. 13 to 17 show a multiplier according to a first embodiment of the present invention, which is composed of bipolar transistors.

In Fig. 13, four bipolar transistors Q1, Q2, Q3 and Q4 and a first constant current source 1 (current: I₀) for driving the transistors Q1, Q2, Q3 and Q4 constitute a first quadritail cell. Four bipolar transistors Q5, Q6, Q7 and Q8 and a second constant current source 2 (current: I₀) for driving the transistors Q5, Q6, Q7 and Q8 constitute a second quadritail cell. These eight transistors Q1, Q2, Q3, Q4, Q5, Q6, Q7 and Q8 have the same emitter area.

In the first quadritail cell, the transistors Q1 and Q3 compose a first pair whose output ends or collectors are coupled together, and the transistors Q2 and Q4 compose a second pair whose output ends or collectors are coupled together. Emitters of the transistors Q1, Q2, Q3 and Q4 are connected in common to the first constant current source 1. Bases of the transistors Q3 and Q4 are coupled together.

A first input voltage Vₓ to be multiplied is applied across bases of the transistors Q1 and Q2. A second input voltage V_{y} to be multiplied is applied to the bases coupled together of the transistors Q3 and Q4 in negative phase.

In the second quadritail cell, the transistors Q5 and Q7 compose a third pair whose output ends or collectors are coupled together, and the transistors Q6 and Q8 compose a fourth pair whose output ends or collectors are coupled together. Emitters of the transistors Q5, Q6, Q7 and Q8 are connected in common to the second constant current source 2. Bases of the transistors Q7 and Q8 are coupled together.

The first input voltage Vₓ is applied across bases of the transistors Q5 and Q6. The second input voltage V_{y} is applied to the bases coupled together of the transistors Q7 and Q8 in positive phase.

Between the first and second quadritail circuits, the collectors coupled together of the transistors Q1 and Q3 and the collectors coupled together of the transistors Q6 and Q8 are further coupled together to form one of differential output ends of the multiplier. The collectors coupled together of the transistors Q2 and Q4 and the collectors of the transistors Q5 and Q7 are further coupled together to form the other of the differential output ends thereof.

In other words, the output end of the first pair of the transistors Q1 and Q3 and that of the fourth pair of the transistors Q6 and Q8, which are in opposite phase to each other, are coupled together. Similarly, the output end of the second pair of the transistors Q2 and Q4 and that of the third pair of the transistors Q5 and Q7, which are in opposite phase to each other, are coupled together. This means that the output ends of the first and fourth pairs are cross-coupled, and those of the second and third pairs are also cross-coupled.

Load resistors (resistance: R_{L}) 3 and 4 are connected to the differential output ends of the multiplier, respectively. A power source voltage V_{CC} is applied through the load resistor 3 to the first and fourth pairs, and it is applied through the load resistor 4 to the second and third pairs.

The second input voltage V_{y} is applied across the bases coupled together of the transistors Q7 and Q8 and the bases coupled together of the transistors Q3 and Q4.

With the multiplier having the above-described configuration, we suppose that the transistors Q1, Q2, Q3, Q4, Q5, Q6, Q7 and Q8 are matched in characteristic and the base-width modulation can be ignored. Then, collector currents I_{C1}, I_{C2}, I_{C3} and I_{c4} of the respective transistors Q1, Q2, Q3 and Q4 can be expressed as the following equations 1, 2 and 3, respectively.

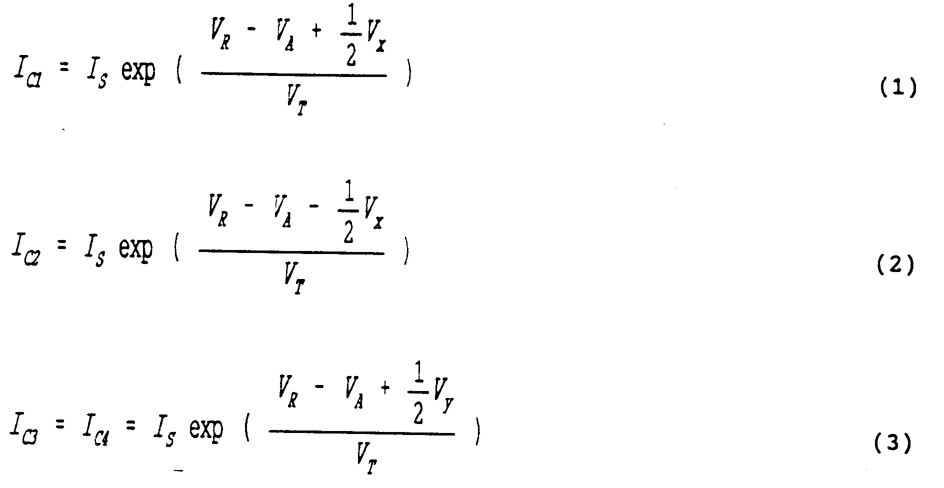

In the equations 1, 2 and 3, V_{T} is the thermal voltage of the transistors Q1 to Q4 defined as ${\text{V}}_{\text{T}} \text{= kT/q}$ where k is the Boltzmann's constant, T is absolute temperature in degrees Kelvin and q is the charge of an electron. Also, I_{S} is the saturation current, V_{R} is a direct current (dc) component of the first input voltage, and V_{A} is a common emitter voltage of the transistors Q1, Q2, Q3 and Q4 of the first quadritail cell.

A tail current of the first quadritail cell satisfies the following equation.${\text{I}}_{\text{C1}} {\text{+ I}}_{\text{C2}} {\text{+ I}}_{\text{C3}} {\text{+ I}}_{\text{C4}} {\text{= α}}_{\text{F}} {\text{I}}_{\text{0}}$ where α_{F} is the dc common-base current gain factor of the transistors.

The common term ${\text{I}}_{\text{S}} {\text{·exp{(V}}_{\text{R}} {\text{- V}}_{\text{A}} {\text{)/V}}_{\text{T}} \text{}}$ contained in the equations 1, 2 and 3 is given as the following equation 5 by solving the equations 1 to 4.

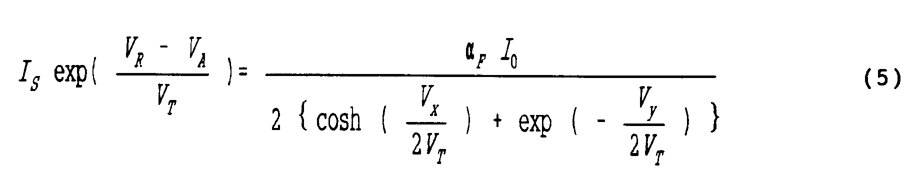

Similarly, the same equations are obtained about the second quadritail cell of the transistors Q5 to Q8, so that a differential output current ΔI_{B} is given as the following equation 6, where I_{C5}, I_{C6}, I_{C7} and I_{C8} are collector currents of the respective transistors Q5, Q6, Q7 and Q8 .

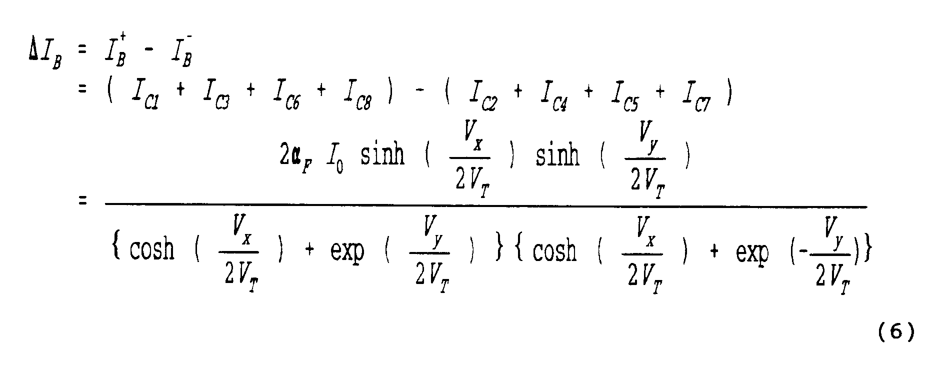

From the equation 6, it is seen that the multiplier has a limiting characteristic concerning the second input voltage V_{y} while it does not have a limiting characteristic concerning the first input voltage Vₓ.

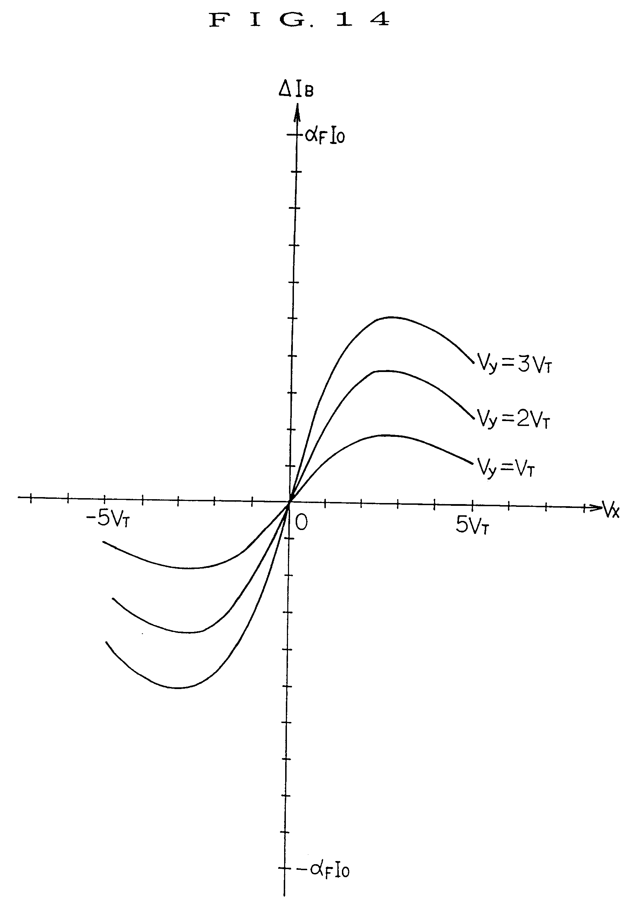

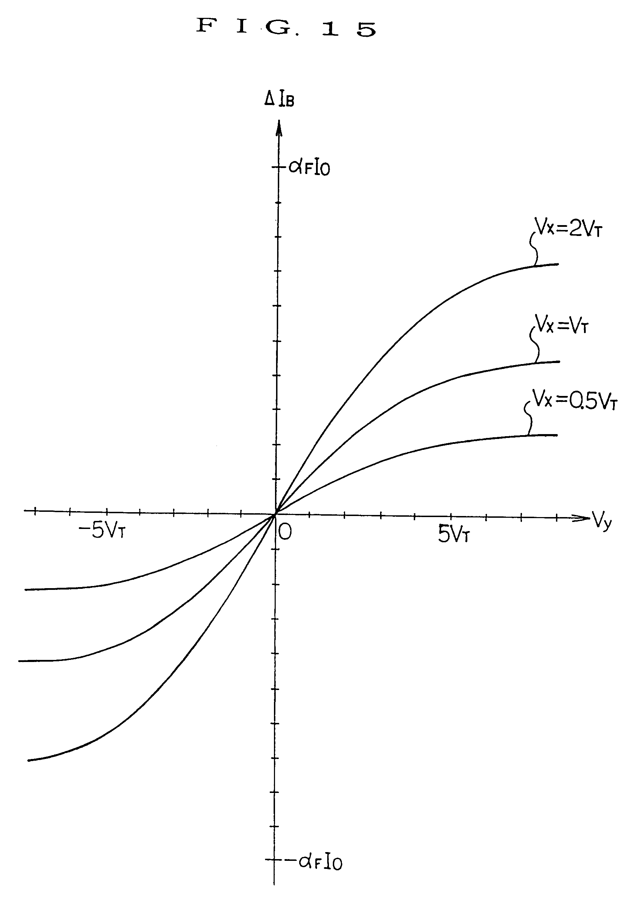

The transfer characteristics of the multiplier of the first embodiment concerning the first and second input voltage Vₓ and V_{y} are shown in Figs. 14 and 15, respectively. Fig. 14 shows the relationship between the differential output current ΔI_{B} and the first input voltage Vₓ with the second input voltage V_{y} as a parameter. Fig. 15 shows the relationship between the differential output current ΔI_{B} and the second input voltage V_{y} with the first input voltage Vₓ as a parameter.

As seen from Figs. 14 and 15, the second input voltage V_{y} is wider in superiorly linear range while the first input voltage Vₓ is substantially equal in superiorly linear range to that in Fig. 2. This means that the multiplier of the first embodiment is improved in a superiorly linear range of the second input voltage V_{y}.

The transconductance characteristics of the multiplier can be given by differentiating the differential output current ΔI_{B} by the first or second input voltage Vₓ or V_{y} in the equation 6 as shown in the following equations 7 and 8, respectively.

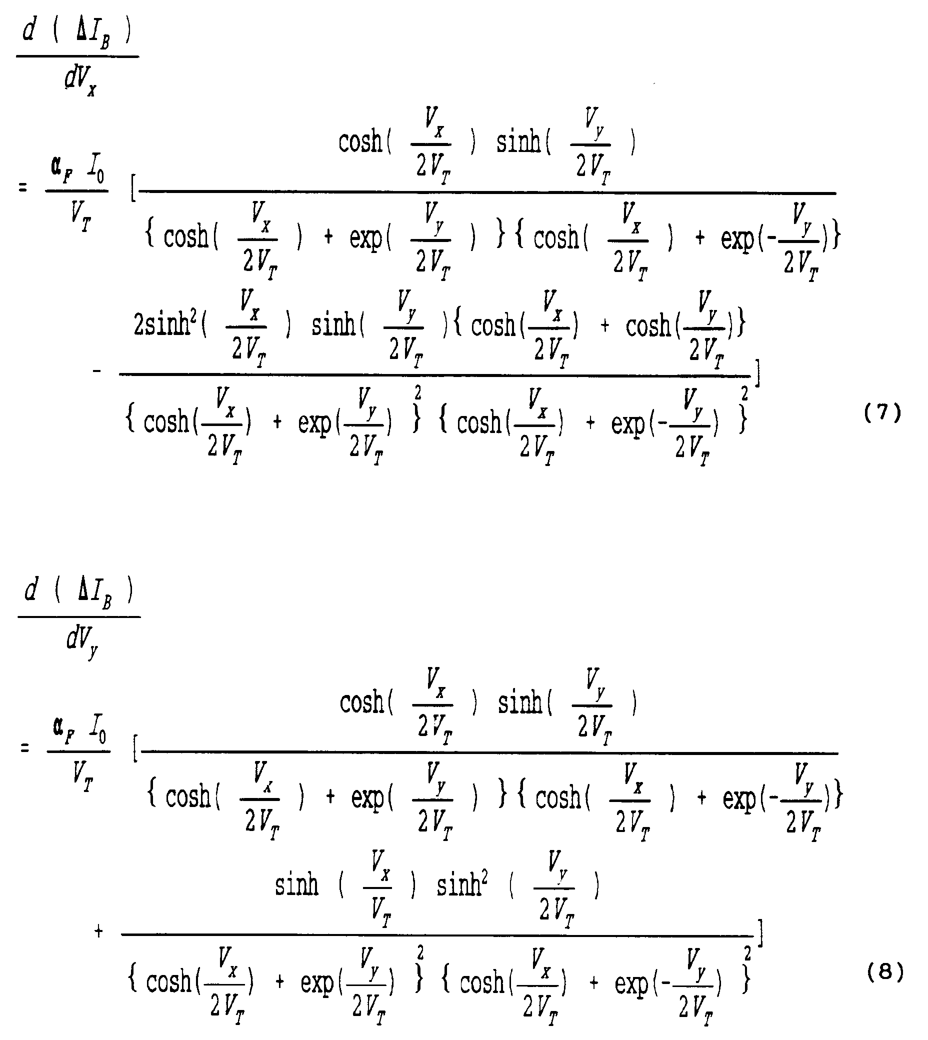

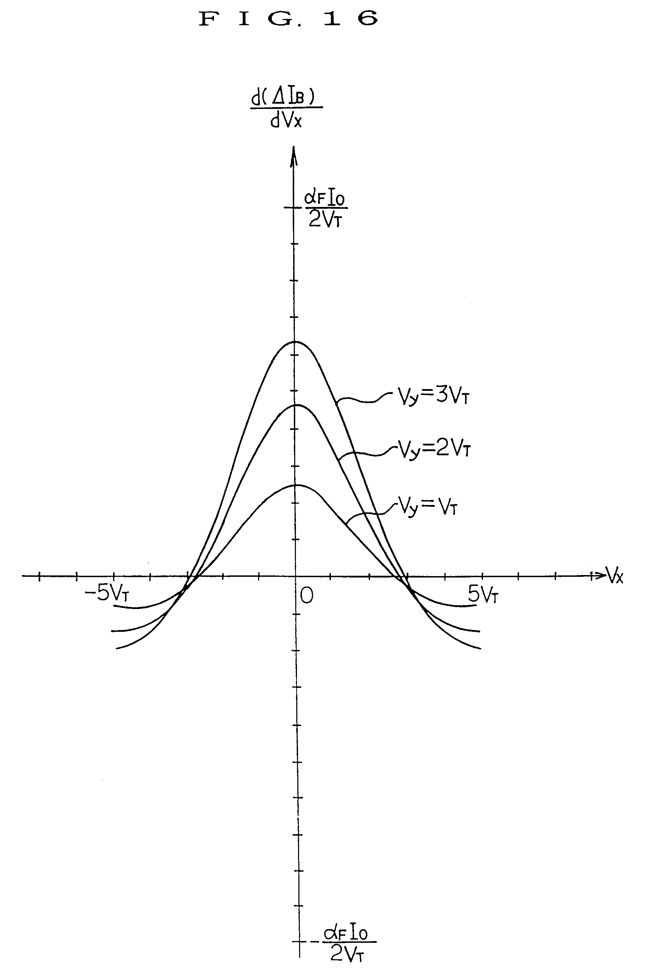

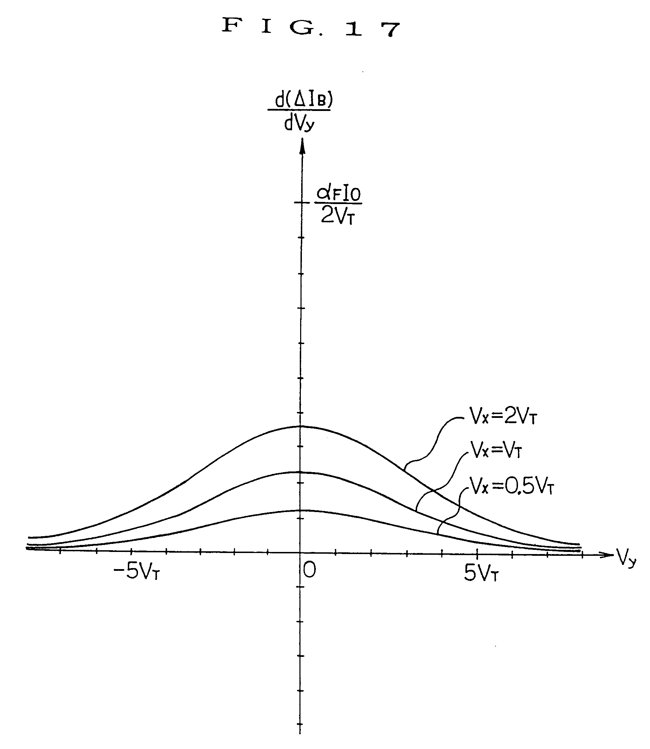

The transconductance characteristics obtained from the equations 7 and 8 are shown in Figs. 16 and 17. Fig. 16 shows the relationship between the transconductance and the first input voltage Vₓ with the second input voltage V_{y} as a parameter. Fig. 17 shows the relationship between the transconductance and the second input voltage V_{y} with the first input voltage Vₓ as a parameter.

### [Second Embodiment]

Fig. 18 shows a multiplier according to a second embodiment of the present invention, which is equivalent to a circuit obtained by replacing the bipolar transistors Q1, Q2, Q3, Q4, Q5, Q6, Q7 and Q8 with MOS transistors M1, M2, M3, M4, M5, M6, M7 and M8, respectively.

In Fig. 18, the MOS transistors M1, M2, M3 and M4 and a first constant current source 5 (current: I₀) for driving the transistors M1, M2, M3 and M4 constitute a first quadritail cell, and four MOS transistors M5, M6, M7 and M8 and a second constant current source 6 (current: I₀) for driving the transistors M5, M6, M7 and M8 constitute a second quadritail cell. These eight transistors M1, M2, M3, M4, M5, M6, M7 and M8 have the same capacity or a ratio (**W/L**) of a gate-width **W** and a gate-length **L**.

In the first quadritail cell, the transistors M1 and M3 compose a first pair whose output ends or drains are coupled together, and the transistors M2 and M4 compose a second pair whose output ends or drains are coupled together. Sources of the transistors M1, M2, M3 and M4 are connected in common to the first constant current source 5. Gates of the transistors M3 and M4 are coupled together.

A first input voltage Vₓ to the multiplier is applied across gates of the transistors M1 and M2. A second input voltage V_{y} to the multiplier is applied to the gates coupled together of the transistors M3 and M4 in negative phase.

In the second quadritail cell, the transistors M5 and M7 compose a third pair whose output ends or drains are coupled together, and the transistors M6 and M8 compose a fourth pair whose output ends or drains are coupled together. Sources of the transistors M5, M6, M7 and M8 are connected in common to the second constant current source 6. Gates of the transistors M7 and M8 are coupled together.

The first input voltage Vₓ is applied across gates of the transistors M5 and M6. The second input voltage V_{y} is applied to the gates coupled together of the transistors M7 and M8 in positive phase.

Between the first and second quadritail circuits, the drains coupled together of the transistors M1 and M3 and the drains coupled together of the transistors M6 and M8 are further coupled together to form one of differential output ends of the multiplier. The drains coupled together of the transistors M2 and M4 and the drains of the transistors M5 and M7 are further coupled together to form the other of the differential output ends.

In other words, the output end of the first pair of the transistors M1 and M3 and that of the fourth pair of the transistors M6 and M8, which are in opposite phase to each other, are coupled together. Similarly, the output end of the second pair of the transistors M2 and M4 and that of the third pair of the transistors M5 and M7, which are in opposite phase to each other, are coupled together. This means that the output ends of the first and fourth pairs are cross-coupled, and those of the second and third pairs are also cross-coupled.

Load resistors (resistance: R_{L}) 7 and 8 are connected to the differential output ends of the multiplier, respectively. A power source voltage V_{CC} is applied through the load resistor 7 to the first and fourth pairs, and is applied through the load resistor 8 to the second and third pairs.

The second input voltage V_{y} is applied across the gates coupled together of the transistors M7 and M8 and the gates coupled together of the transistors M3 and M4.

With the multiplier of the second embodiment, we suppose that the transistors M1, M2, M3, M4, M5, M6, M7 and M8 are matched in characteristic and operating in the saturation regions, and the channel-length modulation can be ignored. Also, we suppose that drain currents of these transistors and gate-source voltages thereof have the square-law characteristics, respectively.

The drain currents I_{D1}, I_{D2}, I_{D3} and I_{D4} of the transistors M1, M2, M3 and M4 of the first quadritail cell can be expressed as the following equations 9, 10 and 11, respectively.$\begin{matrix}\begin{matrix}\begin{matrix}{\text{I}}_{\text{D1}} \text{= β (} {\text{V}}_{\text{R}} \text{-} {\text{V}}_{\text{A}} \text{+} \frac{\text{1}}{\text{2}} {\text{V}}_{\text{x}} \text{-} {\text{V}}_{\text{TH}} {\text{)}}^{\text{2}} \text{(} {\text{V}}_{\text{R}} \text{-} {\text{V}}_{\text{A}} \text{+} \frac{\text{1}}{\text{2}} {\text{V}}_{\text{X}} \text{≥} {\text{V}}_{\text{TH}} \text{)}\end{matrix} \\ \begin{matrix}{\text{I}}_{\text{D2}} \text{= β (} {\text{V}}_{\text{R}} \text{-} {\text{V}}_{\text{A}} \text{-} \frac{\text{1}}{\text{2}} {\text{V}}_{\text{x}} \text{-} {\text{V}}_{\text{TH}} {\text{)}}^{\text{2}} \text{(} {\text{V}}_{\text{R}} \text{-} {\text{V}}_{\text{A}} \text{-} \frac{\text{1}}{\text{2}} {\text{V}}_{\text{Y}} \text{≥} {\text{V}}_{\text{TH}} \text{)}\end{matrix} \\ \begin{matrix}{\text{I}}_{\text{D3}} \text{=} {\text{I}}_{\text{D4}} \text{= β (} {\text{V}}_{\text{R}} \text{-} {\text{V}}_{\text{A}} \text{-} \frac{\text{1}}{\text{2}} {\text{V}}_{\text{y}} \text{-} {\text{V}}_{\text{TH}} {\text{)}}^{\text{2}} \text{(} {\text{V}}_{\text{R}} \text{-} {\text{V}}_{\text{A}} \text{-} \frac{\text{1}}{\text{2}} {\text{V}}_{\text{Y}} \text{≥} {\text{V}}_{\text{TH}} \text{)}\end{matrix}\end{matrix}\end{matrix}$

In the equations 9, 10 and 11, β is the transconductance parameter of these MOS transistors. Here, β is expressed as µ(C_{OX}/2)(W/L) where µ is the effective carrier mobility, C_{OX} is the gate oxide capacitance per unit area, and W and L are a gate-width and a gate-length of these transistors, respectively. Also, V_{TH} is the threshold voltage and V_{R} is a dc component of the first input voltage Vₓ, and V_{A} is the common source voltage of the transistors of the first quadritail cell.

A tail current of the first quadritail cell is expressed as the following equation 12.${\text{I}}_{\text{D1}} {\text{+ I}}_{\text{D2}} {\text{+ I}}_{\text{D3}} {\text{+ I}}_{\text{D4}} {\text{= I}}_{\text{0}}$

Similarly, the same equations are obtained about the transistors M5, M6, M7 and M8 of the second quadritail cell, so that a differential output current ΔI_{M} is given as the following equation 13, 14, 15, 16, 17 and 18, where I_{D1}, I_{D2}, I_{D3} and I_{D4} are drain currents of the transistors M5, M6, M7 and M8.

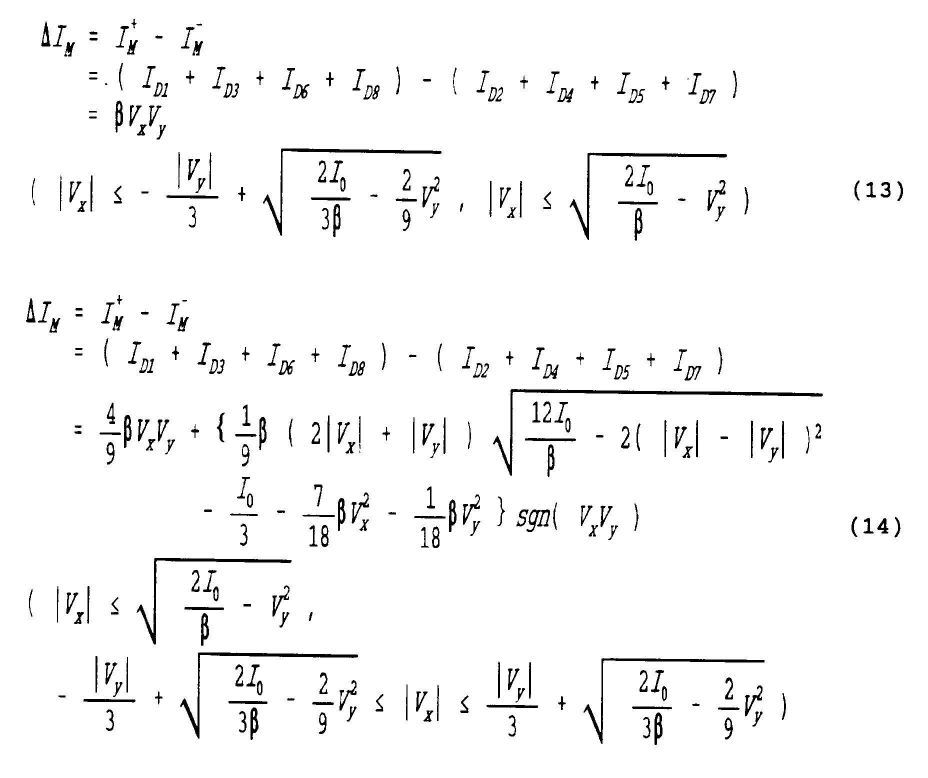

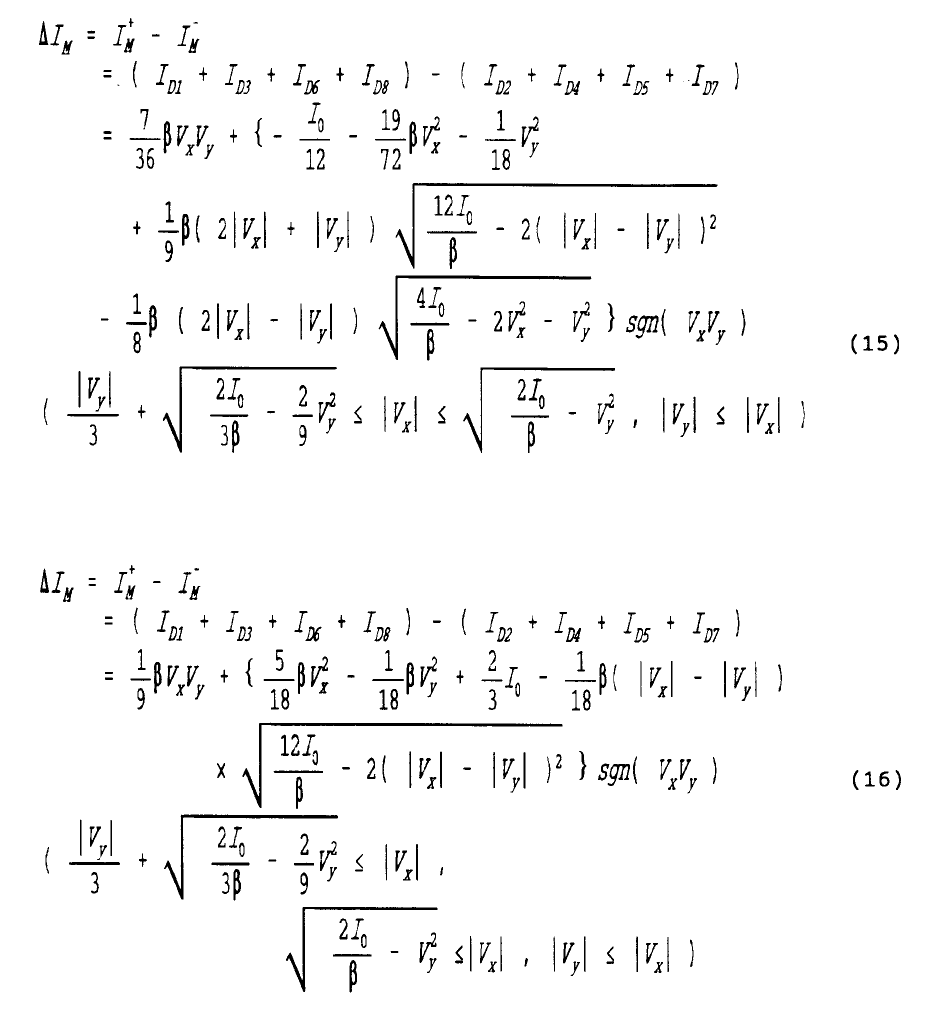

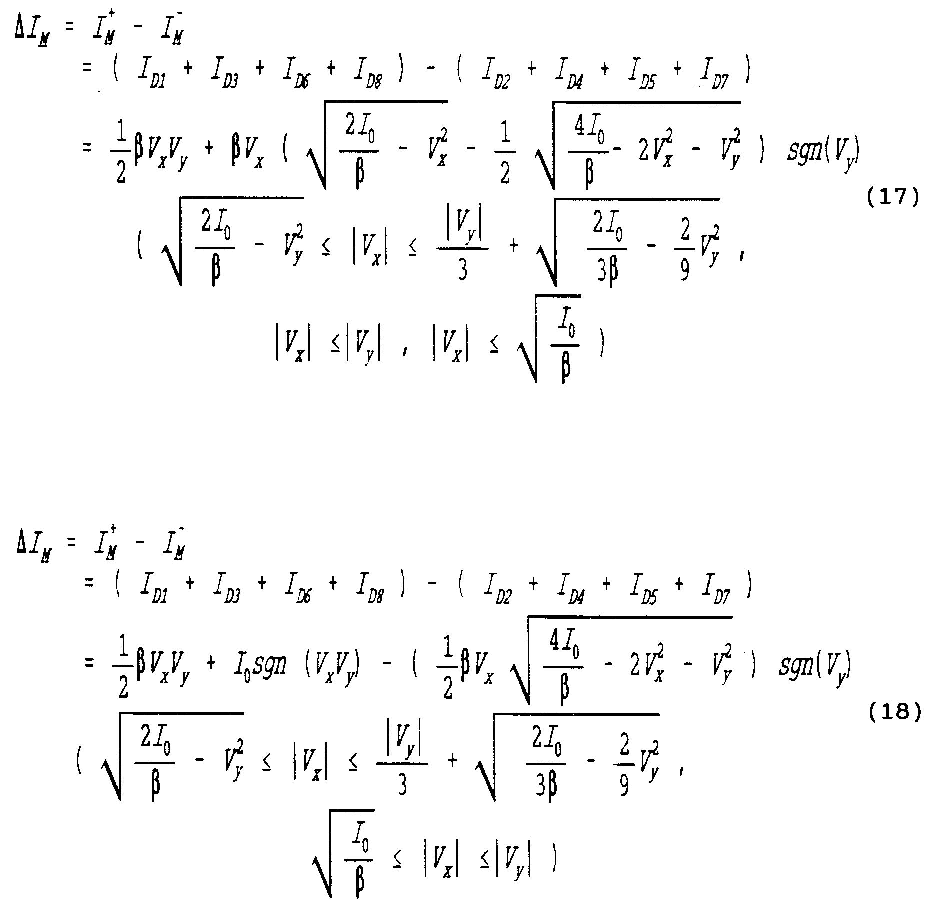

From the equations 13 to 18, it is seen that when each of the MOS transistors has the square-law characteristic, the multiplier of the second embodiment has an ideal multiplication characteristic within the input voltage ranges where all of the MOS transistors M1 to M8 do not cut-off. It is also seen that the multiplication characteristic of the multiplier deviates from the ideal one according to increase of the input voltages due to cut-off of the transistors.

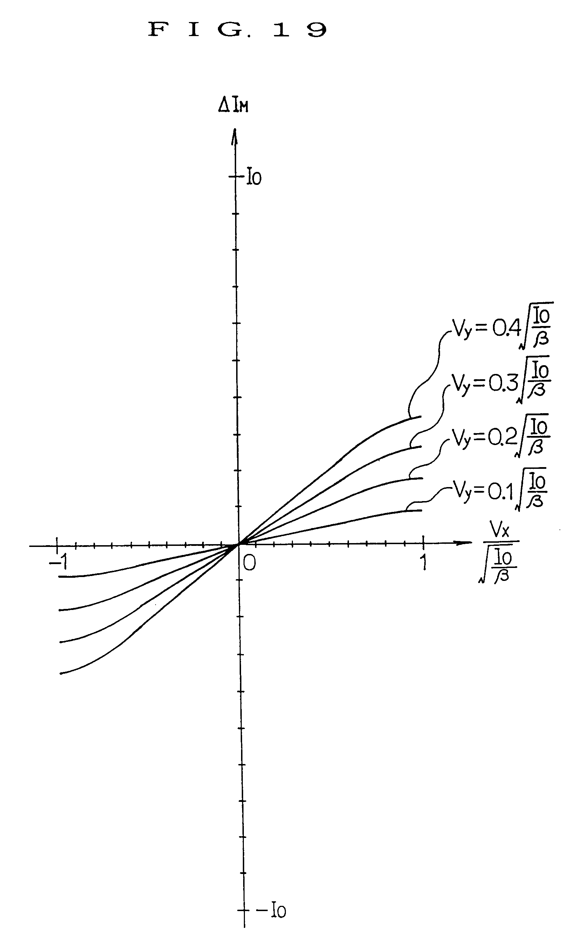

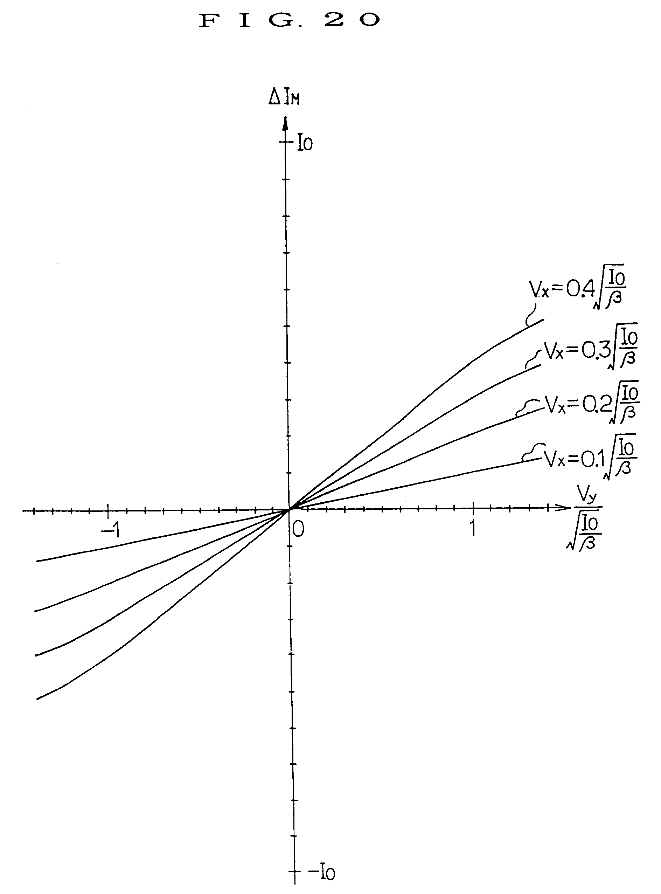

The transfer characteristics of the multiplier of the second embodiment concerning the first and second input voltage Vₓ and V_{y} are shown in Figs. 19 and 20, respectively, which are obtained from the equations 13 to 18. Fig. 19 shows the relationship between the differential output current ΔI_{M} and the first input voltage Vₓ with the second input voltage V_{y} as a parameter. Fig. 20 shows the relationship between the differential output current ΔI_{M} and the second input voltage V_{y} with the first input voltage Vₓ as a parameter. In Figs. 19 and 20, the input voltages Vₓ and V_{y} are normalized by (I₀/β)^{1/2}.

As seen from Figs. 19 and 20, both of the first and second input voltages Vₓ and V_{y} are remarkably wide in superiorly linear range. The superiorly linear range of the second input voltage V_{y} exceeds one (1) in normalized value, or (I₀/β)^{1/2}, which is especially improved. This means that the first and second input voltage ranges can be largely improved in the multiplier of the second embodiment.

The transconductance characteristics of the multiplier, which is given by differentiating the differential output current ΔI_{M} by the first or second input voltage Vₓ or V_{y} in the equations 13 to 18 are given as the following equations 19 to 24.

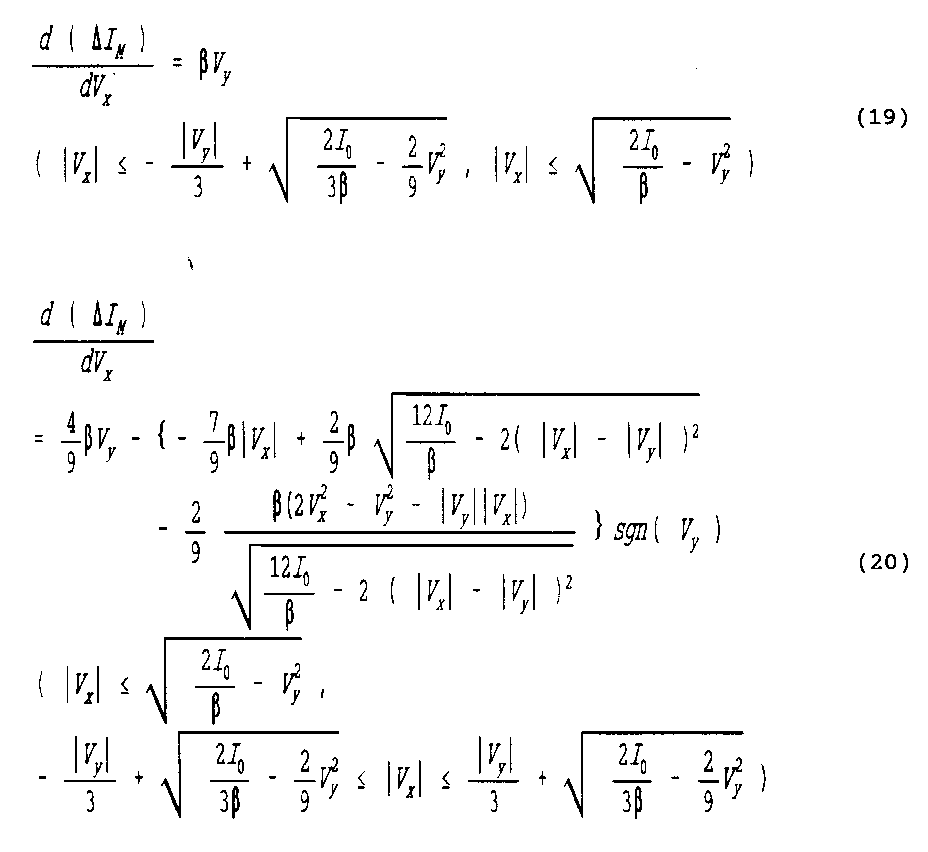

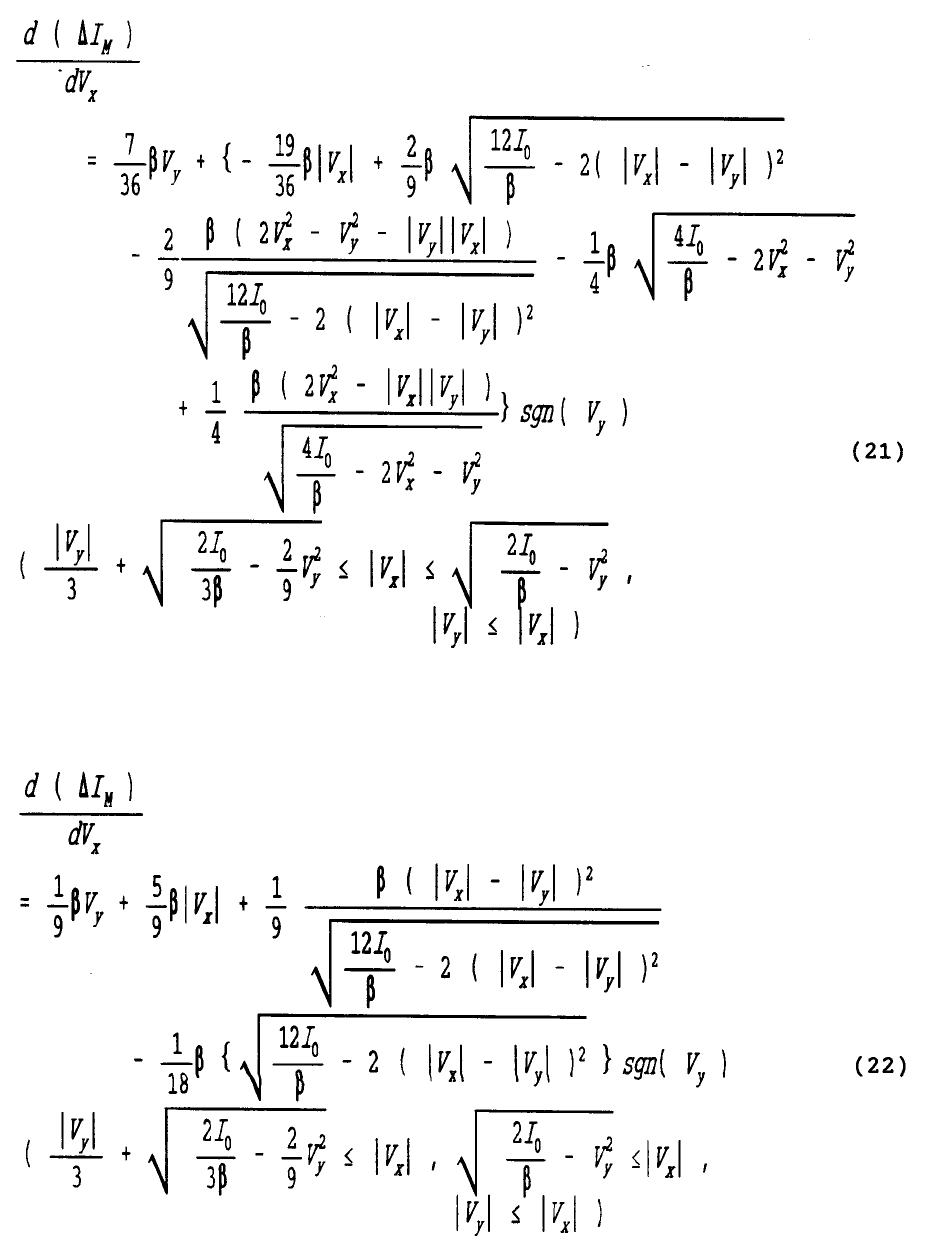

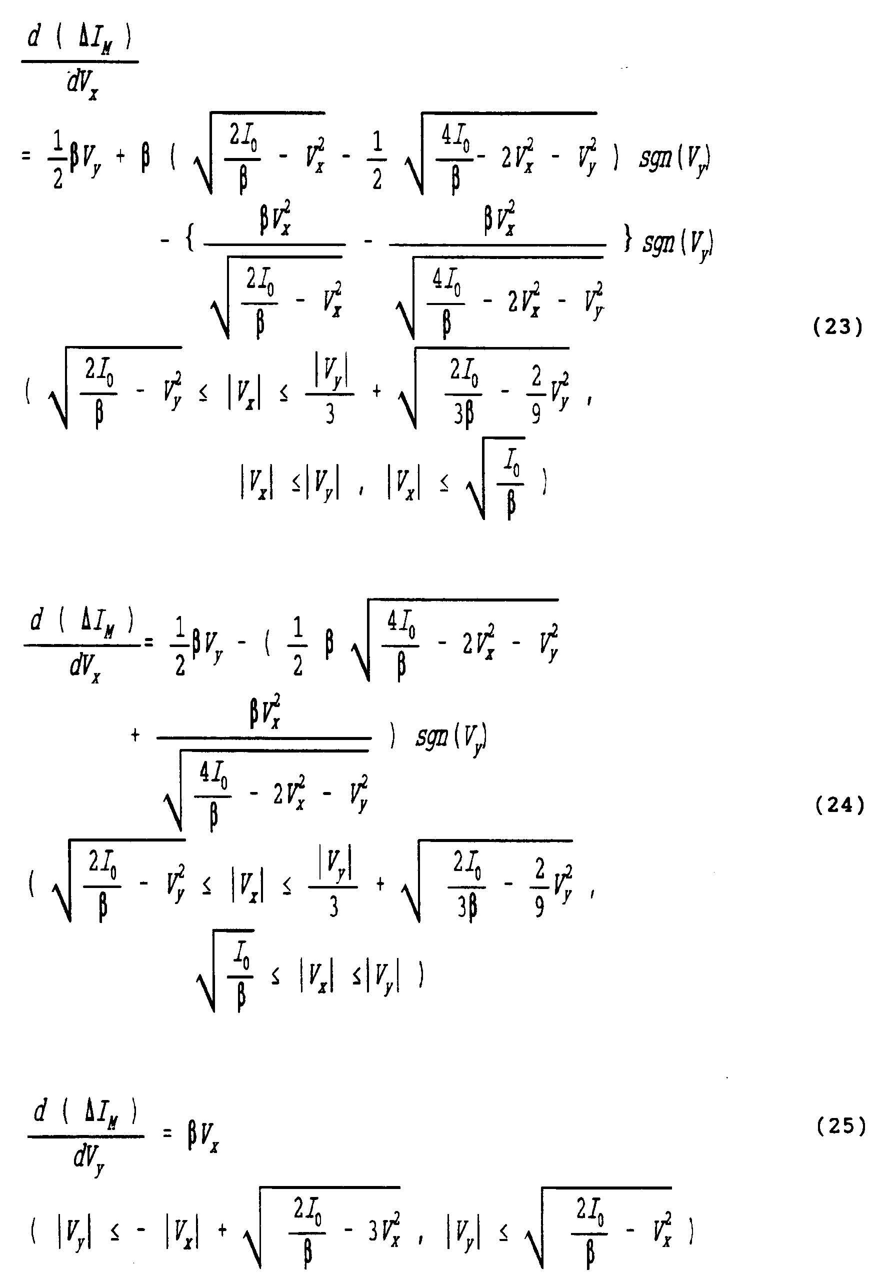

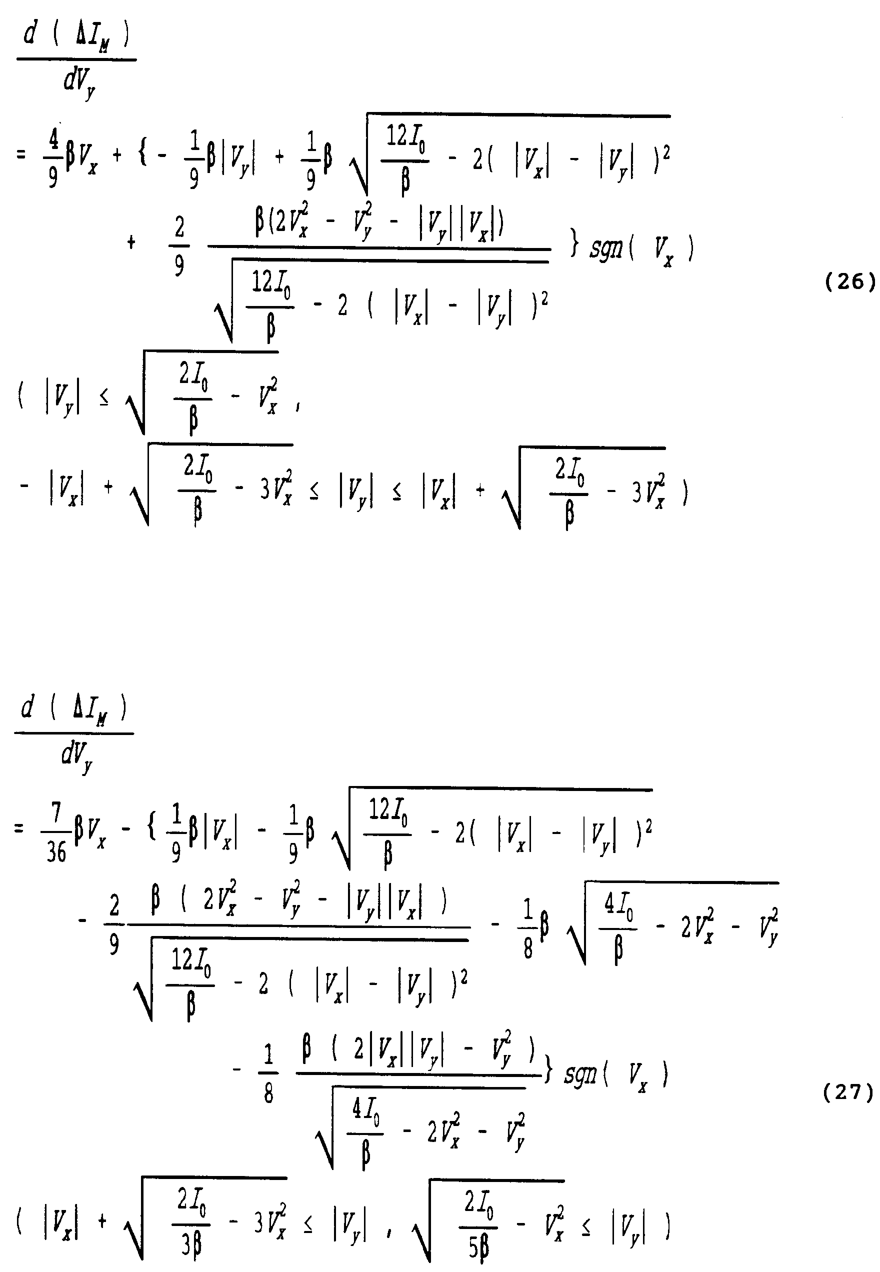

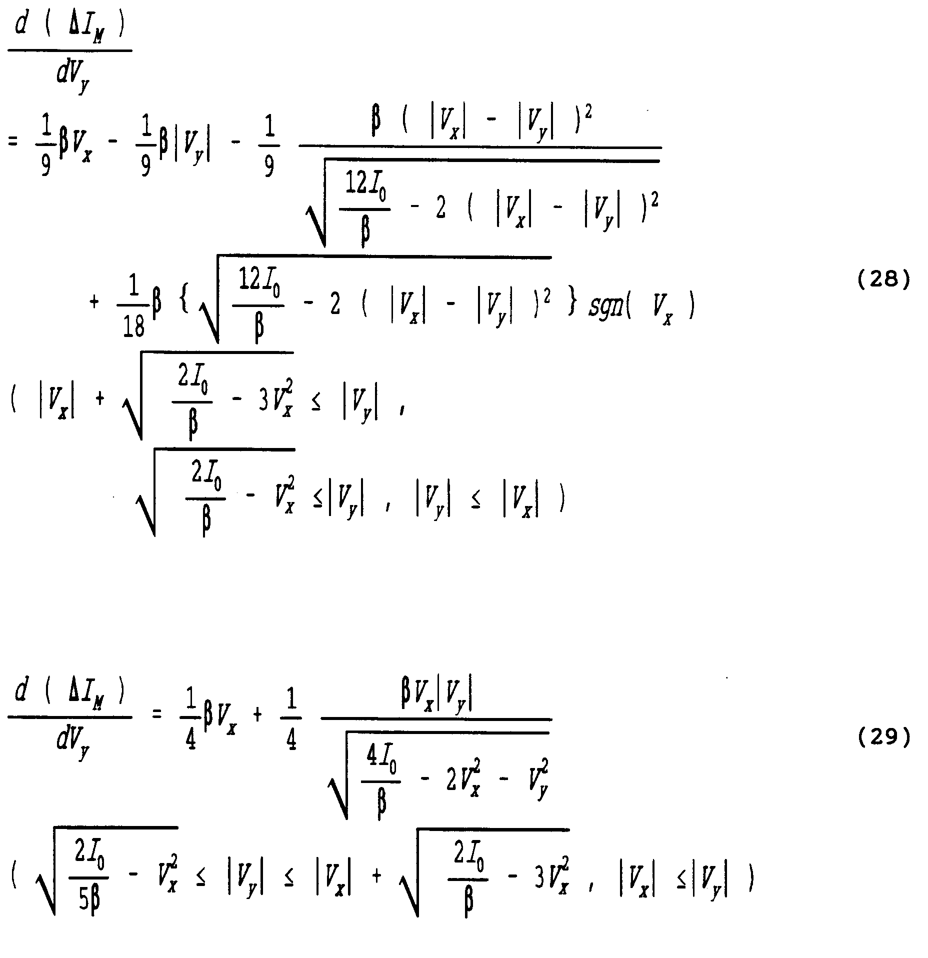

### [Third Embodiment]

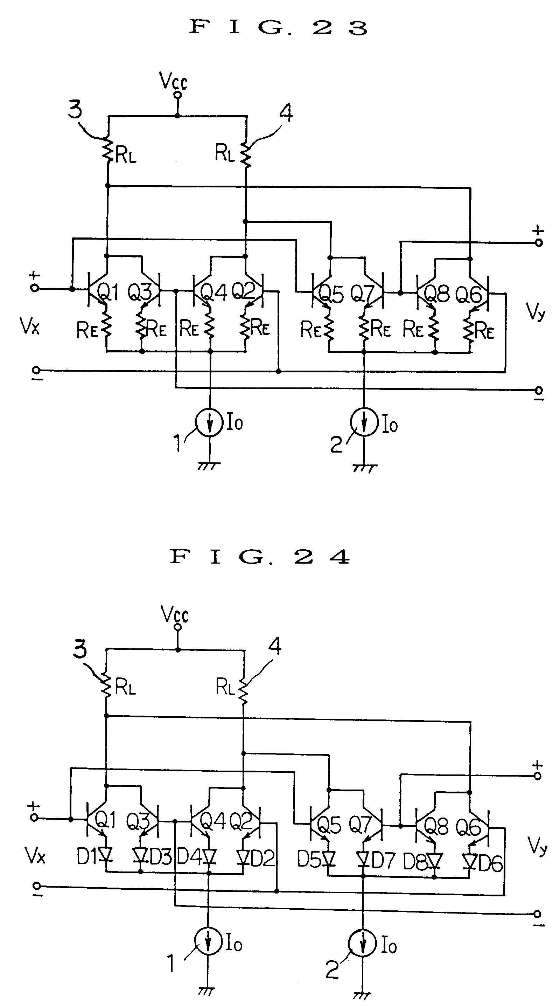

Fig. 23 shows a multiplier according to a third embodiment of the present invention, which is the same in configuration to the multiplier of the first embodiment other than that each of the bipolar transistors Q1, Q2, Q3, Q4, Q5, Q6, Q7 and Q8 has a resistor for degeneration at its emitter. The emitters of the transistors Q1, Q2, Q3 and Q4 are connected in common to the first constant current source 1 through the resistors whose resistance are equal to be R_{E}, respectively. The emitters of the transistors Q5, Q6, Q7 and Q8 are connected in common to the second constant current source 2 through the resistors whose resistance are equal to be R_{E}, respectively.

In the multiplier of the third embodiment, there is an additional advantage that the first and second input voltages Vₓ and V_{y} can be made wider in superiorly linear range than the first embodiment when the "degeneration value" is appropriately determined. Here, the "degeneration value" is defined as a product R_{E}·I₀ of the resistance value R₀ of the respective resistors and the current value I₀ of the respective constant current sources 1 and 2.

### [Fourth Embodiment]

Fig. 24 shows a multiplier according to a fourth embodiment of the present invention, which is the same in configuration to the multiplier of the first embodiment other than that each of the bipolar transistors Q1, Q2, Q3, Q4, Q5, Q6, Q7 and Q8 has a diode for input-voltage division at its emitter. The emitters of the transistors Q1, Q2, Q3 and Q4 are connected in common to the first constant current source 1 through diodes D₁, D₂, D₃ and D₄, respectively. The emitters of the transistors Q5, Q6, Q7 and Q8 are connected in common to the second constant current source 2 through diodes D₅, D₆, D₇ and D₈, respectively.

In the multiplier of the fourth embodiment, similar to the third embodiment, the first and second input voltages Vₓ and V_{y} can be made two times in superiorly linear range as wide as those of the first embodiment while the operating power source voltage is required to be a little higher.

A bipolar transistor is employed as each diode in general, so that the operating power source voltage needs to be higher by the base-emitter voltage V_{BE} of the bipolar transistor, or approximately 0.7 V. However, the operating power source voltage of the fourth embodiment can be made lower than that of the Gilbert multiplier cell since the operating ranges of the first and second input voltages Vₓ and V_{y} do not need to be determined separately like the Gilbert multiplier cell. Therefore, also in the fourth embodiment, the input voltage ranges can be enlarged with a low power source voltage.

Here, one diode is inserted to each transistor, however, **n** in number of diodes connected in series may be inserted thereto where **n** is a natural number. In this case, there arises an additional advantage that the operating input voltage ranges can be increased to be (**n** + 1) times as wide as those (see Figs. 14 and 15) of the first embodiment while the operating power source voltage needs to be higher by a voltage of (**n** x V_{BE}).

As described above, in the multipliers of the first to fourth embodiments, at least one of the first and second input voltages Vₓ and V_{y} to be multiplied can be expanded in superiorly linear range compared with those of the prior-art multipliers even if operating at a low power source voltage such as 3 or 3.3 V.

## Claims

1. An analog multiplier comprising:
a first quadritail circuit;
said first quadritail circuit containing a first pair of first and second bipolar transistors (Q₁, Q₃) whose emitter sizes of the emitter area are the same and whose collectors are coupled together, a second pair of third and fourth bipolar transistors (Q₂, Q₄) whose emitter sizes of the emitter area are the same and whose collectors are coupled together, and a first constant current source (1) for driving said first and second pairs;
the emitters of said first, second, third and fourth transistors being connected in common to said first constant current source (1);
a second quadritail circuit;
said second quadritail circuit containing a third pair of fifth and sixth bipolar transistors (Q₅, Q₇) whose emitter sizes of the emitter area are the same and whose collectors are coupled together, a fourth pair of seventh and eighth bipolar transistors (Q₆, Q₈) whose emitter sizes of the emitter area are the same and whose collectors are coupled together, and a second constant current source (2) for driving said third and fourth pairs;
the emitters of said fifth, sixth, seventh and eighth transistors being connected in common to said second constant current source (2);
the bases of said first and fifth transistors (Q₁, Q₅) being connected together and the bases of said fourth and eighth transistors (Q₂, Q₆) being connected together;
a first input voltage (Vₓ) being applied between these connected bases;
the bases of said second and third transistors (Q₃, Q₄) being coupled together and the bases of said sixth and seventh transistors (Q₇, Q₈) being coupled together;
a second input voltage (V_{y}) being applied between said bases coupled together of said second and third transistors (Q₃, Q₄) and said bases coupled together of said sixth and seventh transistors (Q₇, Q₈);
said collectors coupled together of said first and second transistors (Q₁, Q₃) and said collectors coupled together of said seventh and eighth transistors (Q₆, Q₈) being coupled together to form one of differential output ends of said multiplier; and
said collectors coupled together of said third and fourth transistors (Q₂, Q₄) and said collectors coupled together of said fifth and sixth transistors (Q₅, Q₇) being coupled together to form the other of said differential output ends thereof.

2. The multiplier as claimed in claim 1, wherein
each of said first, second, third and fourth transistors (Q₁, Q₃, Q₂, Q₄) has a resistor (R_{E}) connected to said corresponding emitter, and said emitters of said first, second, third and fourth transistors are connected in common to said first constant current source (1) through said respective resistors (R_{E}); and
each of said fifth, sixth, seventh and eighth transistors (Q₅, Q₇, Q₆, Q₈) has a resistor (R_{E}) connected to said corresponding emitter, and said emitters of said fifth, sixth, seventh and eighth transistors are connected in common to said second constant current source (2) through said respective resistors (R_{E}).

3. The multiplier as claimed in claim 1, wherein
each of said first, second, third and fourth transistors (Q₁, Q₃, Q₂, Q₄) has a diode (D₁, D₃, D₂, D₄) connected to said corresponding emitter, and said emitters of said first, second, third and fourth transistors are connected in common to said first constant current source (1) through said respective diodes; and
each of said fifth, sixth, seventh and eighth transistors (Q5, Q7, Q6, Q8) has a diode (D₅, D₇, D₆, D₈) connected to said corresponding emitter, and said emitters of said fifth, sixth, seventh and eighth transistors are connected in common to said second constant current source (2) through said respective diodes.

4. The multiplier as claimed in claim 1, 2, or 3, wherein load resistors (3, 4) are connected to said differential output ends, respectively,
and an output voltage is extracted from said differential output ends.

5. An analog multiplier comprising:
a first quadritail circuit;
said first quadritail circuit containing a first pair of first and second MOS transistors (M₁, M₃) whose ratios (W/L) of a gate-width and a gate-length are the same and whose drains are coupled together, a second pair of third and fourth MOS transistors (M₂, M₄) whose ratios (W/L) of a gate-width and a gate-length are the same and whose drains are coupled together, and a first constant current source (5) for driving said first and second pairs;
the sources of said first, second, third and fourth transistors being connected in common to said first constant current source (5);
a second quadritail circuit;
said second quadritail circuit containing a third pair of fifth and sixth MOS transistors (M₅, M₇) whose ratios (W/L) of a gate-width and a gate-length are the same and whose drains are coupled together, a fourth pair of seventh and eighth MOS transistors (M₆, M₈) whose ratios (W/L) of a gate-width and a gate-length are the same and whose drains are coupled together, and a second constant current source (6) for driving said third and fourth pairs;
the sources of said fifth, sixth, seventh and eighth transistors being connected in common to said second constant current source (6);
characterized by
the gates of said first and fifth transistors (M₁, M₅) being connected together and the gates of said fourth and eighth transistors (M₂, M₆) being connected together;
a first input voltage (Vₓ) being applied between these connected gates;
the gates of said second and third transistors (M₃, M₄) being coupled together and the gates of said sixth and seventh transistors (M₇, M₈) being coupled together;
a second input voltage (V_{y}) being applied between said gates coupled together of said second and third transistors (M₃, M₄) and said gates coupled together of said sixth and seventh transistor (M₇, M₈);
said drains coupled together of said first and second transistors (M₁, M₃) and said drains coupled together of said seventh and eighth transistors (M₆, M₈) being coupled together to form one of differential output ends of said multiplier; and
said drains coupled together of said third and fourth transistors (M₂, M₄) and said drains coupled together of said fifth and sixth transistors (M₅, M₇) being coupled together to form the other of said differential output ends thereof.

6. The multiplier as claimed in claim 5, wherein load resistors (3, 4) are connected to said differential output ends, respectively, and an output voltage is extracted from said differential output ends.

## Patentansprüche

1. Analogmultiplizierer mit:
einer ersten Quadritail-Schaltung;
wobei die erste Quadritail-Schaltung aufweist: ein erstes Transistorpaar, das aus einem ersten und einem zweiten bipolaren Transistor (Q1, Q3) gebildet wird, deren Emittergrößen bezüglich der Emitterfläche gleich sind und deren Kollektoren miteinander verbunden sind, ein zweites Transistorpaar, das aus einem dritten und einem vierten bipolaren Transistor (Q2, Q4) gebildet wird, deren Emittergrößen bezüglich der Emitterfläche gleich sind und deren Kollektoren miteinander verbunden sind, und eine erste Konstantstromquelle (1) zum Betreiben des ersten und des zweiten Transistorpaars;
wobei die Emitter des ersten, des zweiten, des dritten und des vierten Transistors gemeinsam mit der ersten Konstantstromquelle (1) verbunden sind;
einer zweiten Quadritail-Schaltung;
wobei die zweite Quadritail-Schaltung aufweist: ein drittes Transistorpaar, das aus einem fünften und einem-sechsten bipolaren Transistor (Q5, Q7) gebildet wird, deren Emittergrößen bezüglich der Emitterfläche gleich sind und deren Kollektoren miteinander verbunden sind, ein viertes Transistorpaar, das aus einem siebenten und einem achten bipolaren Transistor (Q6, Q8) gebildet wird, deren Emittergrößen bezüglich der Emitterfläche gleich sind und deren Kollektoren miteinander verbunden sind, und eine zweite Konstantstromquelle (2) zum Betreiben des dritten und des vierten Transistorpaars;
wobei die Emitter des fünften, des sechsten, des siebenten und des achten Transistors gemeinsam mit der zweiten Konstantstromquelle (2) verbunden sind;
die Basen des ersten und des fünften Transistors (Q1, Q5) miteinander verbunden sind; und
die Basen des vierten und des achten Transistors (Q2, Q6) miteinander verbunden sind;
eine erste Eingangsspannung (V_{X}) zwischen diese verbundenen Basen angelegt wird;
die Basen des zweiten und des dritten Transistors (Q3, Q4) miteinander verbunden sind; und
die Basen des sechsten und des siebenten Transistors (Q7, Q8) miteinander verbunden sind;
eine zweite Eingangsspannung (V_{Y}) zwischen diese miteinander verbundenen Basen des zweiten und des dritten Transistors (Q3, Q4) und die miteinander verbundenen Basen des sechsten und des siebenten Transistors (Q₇, Q₈) angelegt wird;
die miteinander verbundenen Kollektoren des ersten und des zweiten Transistors (Q1, Q3) und die miteinander verbundenen Kollektoren des siebenten und des achten Transistors (Q6, Q8) miteinander verbunden sind, um ein Differenzausgangsende des Multiplizierers zu bilden; und
die miteinander verbundenen Kollektoren des dritten und des vierten Transistors (Q2, Q4) und die miteinander verbundenen Kollektoren des fünften und des sechsten Transistors (Q5, Q7) miteinander verbunden sind, um das andere Differenzausgangsende des Multiplizierers zu bilden.

2. Multiplizierer nach Anspruch 1, wobei
mit den Emittern des ersten, des zweiten, des dritten und des vierten Transistors (Q1, Q3, Q2, Q4) jeweils ein Widerstand (R_{E}) verbunden ist, und wobei die Emitter des ersten, des zweiten, des dritten und des vierten Transistors über die jeweiligen Widerstände (R_{E}) gemeinsam mit der ersten Konstantstromquelle (1) verbunden sind; und
mit den Emittern des fünften, des sechsten, des siebenten und des achten Transistors (Q5, Q7, Q6, Q8) jeweils ein Widerstand (R_{E}) verbunden ist, und wobei die Emitter des fünften, des sechsten, des siebenten und des achten Transistors über die jeweiligen Widerstände (R_{E}) gemeinsam mit der zweiten Konstantstromquelle (2) verbunden sind.

3. Multiplizierer nach Anspruch 1, wobei
mit den Emittern des ersten, des zweiten, des dritten und des vierten Transistors (Q1, Q3, Q2, Q4) jeweils eine Diode (D₁, D₃, D₂, D₄) verbunden ist, und wobei die Emitter des ersten, des zweiten, des dritten und des vierten Transistors über die jeweiligen Dioden gemeinsam mit der ersten Konstantstromquelle (1) verbunden sind; und
mit den Emittern des fünften, des sechsten, des siebenten und des achten Transistors (Q5, Q7, Q6, Q8) jeweils eine Diode (D₅, D₇, D₆, D₈) verbunden ist, und wobei die Emitter des fünften, des sechsten, des siebenten und des achten Transistors über die jeweiligen Dioden gemeinsam mit der zweiten Konstantstromquelle (2) verbunden sind.

4. Multiplizierer nach Anspruch 1, 2 oder 3, wobei Lasttransistoren (3, 4) jeweils mit den Differenzausgangsenden verbunden sind und eine Ausgangsspannung von den Differenzausgangsenden extrahiert wird.

5. Analogmultiplizierer mit:
einer ersten Quadritail-Schaltung
wobei die erste Quadritail-Schaltung aufweist: ein erstes Transistorpaar, das aus einem ersten und einem zweiten MOS-Transistor (M1, M3) gebildet wird, deren Verhältnis (W/L) einer Gate-Breite zu einer Gate-Länge gleich ist und deren Drain-Elektroden miteinander verbunden sind, ein zweites Transistorpaar, das aus einem dritten und einem vierten MOS-Transistor (M2, M4) gebildet wird, deren Verhältnis (W/L) einer Gate-Breite zu einer Gate-Länge gleich ist und deren Drain-Elektroden miteinander verbunden sind, und eine erste Konstantstromquelle (5) zum Betreiben des ersten und des zweiten Transistorpaars;
wobei die Source-Elektroden des ersten, des zweiten, des dritten und des vierten Transistors gemeinsam mit der ersten Konstantstromquelle (5) verbunden sind;
einer zweiten Quadritail-Schaltung;
wobei die zweite Quadritail-Schaltung aufweist: ein drittes Transistorpaar, das aus einem fünften und einem sechsten MOS-Transistor (M5, M7) gebildet wird, deren Verhältnis (W/L) einer Gate-Breite zu einer Gate-Länge gleich ist und deren Drain-Elektroden miteinander verbunden sind, ein viertes Transistorpaar, das aus einem siebenten und einem achten MOS-Transistor (M6, M8) gebildet wird, deren Verhältnis (W/L) einer Gate-Breite zu einer Gate-Länge gleich ist und deren Drain-Elektroden miteinander verbunden sind, und eine zweite Konstantstromquelle (6) zum Betreiben des dritten und des vierten Transistorpaars;
wobei die Source-Elektroden des fünften, des sechsten, des siebenten und des achten Transistors gemeinsam mit der zweiten Konstantstromquelle (6) verbunden sind;
dadurch gekennzeichnet daß
die Gate-Elektroden des ersten und des fünften Transistors (M1, M5) miteinander verbunden sind; und
die Gate-Elektroden des vierten und des achten Transistors (M2, M6) miteinander verbunden sind;
eine erste Eingangsspannung (V_{X}) zwischen diese verbundenen Gate-Elektroden angelegt wird;
die Gate-Elektroden des zweiten und des dritten Transistors (M3, M4) miteinander verbunden sind; und
die Gate-Elektroden des sechsten und des siebenten Transistors (M7, M8) miteinander verbunden sind;
eine zweite Eingangsspannung (V_{Y}) zwischen die miteinander verbundenen Gate-Elektroden des zweiten und des dritten Transistors (M3, M4) und die miteinander verbundene Gate-Elektroden des sechsten und des siebenten Transistors (M7, M8) angelegt wird;
die miteinander verbundenen Drain-Elektroden des ersten und des zweiten Transistors (M1, M3) und die miteinander verbundenen Drain-Elektroden des siebenten und des achten Transistors (M6, M8) miteinander verbunden sind, um ein Differenzausgangsende des Multiplizierers zu bilden; und
die miteinander verbundenen Drain-Elektroden des dritten und des vierten Transistors (M2, M4) und die miteinander verbundenen Drain-Elektroden des fünften und des sechsten Transistors (M5, M7) miteinander verbunden sind, um das andere Differenzausgangsende des Multiplizierers zu bilden.

6. Multiplizierer nach Anspruch 5, wobei die Lasttransistoren (3, 4) jeweils mit den Differenzausgangsenden verbunden sind und eine Ausgangsspannung von den Differenzausgangsenden extrahiert wird.

## Revendications

1. Multiplicateur analogique comprenant :
un premier circuit à quatre transistors ;
ledit premier circuit à quatre transistors contenant une première paire de premier et deuxième transistors bipolaires (Q₁, Q₃) dont les tailles d'émetteur de la zone d'émission sont les mêmes et dont les collecteurs sont connectés ensemble, une deuxième paire de troisième et quatrième transistors bipolaires (Q₂, Q₄) dont les tailles d'émetteur de la zone d'émission sont les mêmes et dont les collecteurs sont connectés ensemble, et une première source de courant constant (1) pour commander lesdites première et deuxième paires ;
les émetteurs desdits premier, deuxième, troisième et quatrième transistors étant connectés en commun à ladite première source de courant constant (1) ;
un second circuit à quatre transistors ;
ledit second circuit à quatre transistors contenant une troisième paire de cinquième et sixième transistors bipolaires (Q₅, Q₇) dont les tailles d'émetteur de la zone d'émission sont les mêmes et dont les collecteurs sont connectés ensemble, une quatrième paire de septième et huitième transistors bipolaires (Q₆, Q₈) dont les tailles d'émetteur de la zone d'émission sont les mêmes et dont les collecteurs sont connectés ensemble, et une seconde source de courant constant (2) pour commander lesdites troisième et quatrième paires ;
les émetteurs desdits cinquième, sixième, septième et huitième transistors étant connectés en commun à ladite seconde source de courant constant (2) ;
les bases desdits premier et cinquième transistors (Q₁, Q₅) étant connectées ensemble et les bases desdits quatrième et huitième transistors (Q₂, Q₆) étant connectées ensemble ;
une première tension d'entrée (Vₓ) étant appliquée entre ces bases connectées ;
les bases desdits deuxième et troisième transistors (Q₃, Q₄) étant connectées ensemble, et les bases desdits sixième et septième transistors (Q₇, Q₈) étant connectées ensemble ;
une seconde tension d'entrée (V_{y}) étant appliquée entre lesdites bases connectées ensemble desdits deuxième et troisième transistors (Q₃, Q₄) et lesdites bases connectées ensemble desdits sixième et septième transistors (Q₇, Q₈) ;
lesdits collecteurs connectés ensemble desdits premier et deuxième transistors (Q₁, Q₃) et lesdits collecteurs connectés ensemble desdits septième et huitième transistors (Q₆, Q₈) étant connectés ensemble pour former l'une des extrémités de sortie différentielles dudit multiplicateur ; et
lesdits collecteurs connectés ensemble desdits troisième et quatrième transistors (Q₂, Q₄) et lesdits collecteurs connectés ensemble desdits cinquième et sixième transistors (Q₅, Q₇) étant connectés ensemble pour former l'autre desdites extrémités de sortie différentielles de celui-ci.

2. Multiplicateur selon la revendication 1, dans lequel
chacun desdits premier, deuxième, troisième et quatrième transistors (Q₁, Q₃, Q₂, Q₄) a une résistance (R_{E}) connectée audit émetteur correspondant, et lesdits émetteurs desdits premier, deuxième, troisième et quatrième transistors sont connectés en commun à ladite première source de courant constant (1) par l'intermédiaire desdites résistances respectives (R_{E}) ; et
chacun desdits cinquième, sixième, septième et huitième transistors (Q₅, Q₇, Q₆, Q₈) a une résistance (R_{E}) connectée audit émetteur correspondant, et lesdits émetteurs desdits cinquième, sixième, septième et huitième transistors sont connectés en commun à ladite seconde source de courant constant (2) par l'intermédiaire desdites résistances respectives (R_{E}).

3. Multiplicateur selon la revendication 1, dans lequel
chacun desdits premier, deuxième, troisième et quatrième transistors (Q₁, Q₃, Q₂, Q₄) a une diode (D₁, D₃, D₂, D₄) connectée audit émetteur correspondant, et lesdits émetteurs desdits premier, deuxième, troisième et quatrième transistors sont connectés en commun à ladite première source de courant constant (1) par l'intermédiaire desdites diodes respectives ; et
chacun desdits cinquième, sixième, septième et huitième transistors (Q₅, Q₇, Q₆, Q₈) a une diode (D₅, D₇, D₆, D₈) connectée audit émetteur correspondant, et lesdits émetteurs desdits cinquième, sixième, septième et huitième transistors sont connectés en commun à ladite seconde source de courant constant (2) par l'intermédiaire desdites diodes respectives.

4. Multiplicateur selon la revendication 1, 2 ou 3, dans lequel des résistances de charge (3, 4) sont connectées auxdites extrémités de sortie différentielles, respectivement,
et une tension de sortie est extraite desdites extrémités de sortie différentielles.

5. Multiplicateur analogique comprenant :
un premier circuit à quatre transistors ;
ledit premier circuit à quatre transistors contenant une première paire de premier et deuxième transistors MOS (M₁, M₃) dont les rapports (W/L) largeur de grille/longueur de grille sont les mêmes et dont les drains sont connectés ensemble, une deuxième paire de troisième et quatrième transistors MOS (M₂, M₄) dont les rapports (W/L) largeur de grille/longueur de grille sont les mêmes et dont les drains sont connectés ensemble, et une première source de courant constant (5) pour commander lesdites première et deuxième paires ;
les sources desdits premier, deuxième, troisième et quatrième transistors étant connectées en commun à ladite première source de courant constant (5) ;
un second circuit à quatre transistors ;
ledit second circuit à quatre transistors contenant une troisième paire de cinquième et sixième transistors MOS (M₅, M₇) dont les rapports (W/L) largeur de grille/longueur de grille sont les mêmes et dont les drains sont connectés ensemble, une quatrième paire de septième et huitième transistors MOS (M₆, M₈) dont les rapports (W/L) largeur de grille/longueur de grille sont les mêmes et dont les drains sont connectés ensemble, et une seconde source de courant constant (6) pour commander lesdites troisième et quatrième paires ;
les sources desdits cinquième, sixième, septième et huitième transistors étant connectées en commun à ladite seconde source de courant constant (6) ;
caractérisé en ce que :
les grilles desdits premier et cinquième transistors (M₁, M₅) étant connectées ensemble, et les grilles desdits quatrième et huitième transistors (M₂, M₆) étant connectées ensemble ;
une première tension d'entrée (Vₓ) étant appliquée entre ces grilles connectées ;
les grilles desdits deuxième et troisième transistors (M₃, M₄) étant connectées ensemble, et les grilles desdits sixième et septième transistors (M₇, M₈) étant connectées ensemble ;
une seconde tension d'entrée (V_{y}) étant appliquée entre lesdites grilles connectées ensemble desdits deuxième et troisième transistors (M₃, M₄) et lesdites grilles connectées ensemble desdits sixième et septième transistors (M₇, M₈) ;
lesdits drains connectés ensemble desdits premier et deuxième transistors (M₁, M₃) et lesdits drains connectés ensemble desdits septième et huitième transistors (M₆, M₈) étant connectés ensemble pour former l'une des extrémités de sortie différentielles dudit multiplicateur ; et
lesdits drains connectés ensemble desdits troisième et quatrième transistors (M₂, M₄) et lesdits drains connectés ensemble desdits cinquième et sixième transistors (M₅, M₇) étant connectés ensemble pour former l'autre desdites extrémités de sortie différentielles de celui-ci.

6. Multiplicateur selon la revendication 5, dans lequel des résistances de charge (3, 4) sont connectées auxdites extrémités de sortie différentielles, respectivement, et dans lequel une tension de sortie est extraite desdites extrémités de sortie différentielles.
